(19) Europäisches Patentamt
European Patent Office
Office européen des brevets

(11) **EP 3 132 365 B1**

(12) **FASCICULE DE BREVET EUROPEEN**

(45) Date de publication et mention de la délivrance du brevet:
**06.12.2023 Bulletin 2023/49**

(21) Numéro de dépôt: **15719812.8**

(22) Date de dépôt: **10.04.2015**

(51) Classification Internationale des Brevets (IPC):
***G06F 30/30*** *(2020.01)*

(52) Classification Coopérative des Brevets (CPC):
**G06F 30/30**

(86) Numéro de dépôt international:
**PCT/FR2015/050969**

(87) Numéro de publication internationale:
**WO 2015/159001 (22.10.2015 Gazette 2015/42)**

(54) **PROCEDE DE SYNTHESE AUTOMATIQUE DE CIRCUITS, DISPOSITIF ET PROGRAMME D'ORDINATEUR ASSOCIES**

VERFAHREN ZUR AUTOMATISCHEN SYNTHESE VON SCHALTUNGEN, VORRICHTUNG UND COMPUTERPROGRAMM IM ZUSAMMENHANG DAMIT

METHOD OF AUTOMATIC SYNTHESIS OF CIRCUITS, DEVICE AND COMPUTER PROGRAM ASSOCIATED THEREWITH

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.04.2014 FR 1453308**

(43) Date de publication de la demande:
**22.02.2017 Bulletin 2017/08**

(73) Titulaire: **INRIA - Institut National de Recherche en Informatique et en Automatique**
**78150 Le Chesnay (FR)**

(72) Inventeurs:
• **ALIAS, Christophe**
**69007 Lyon (FR)**
• **PLESCO, Alexandru**
**69003 Lyon (FR)**

(74) Mandataire: **Vidon Brevets & Stratégie**
**16B, rue de Jouanet**
**BP 90333**
**35703 Rennes Cedex 7 (FR)**

(56) Documents cités:
**WO-A2-2010/140883**

• **SVEN VAN HAASTREGT ET AL: "Enabling Automatic Pipeline Utilization Improvement in Polyhedral Process Network Implementations", APPLICATION-SPECIFIC SYSTEMS, ARCHITECTURES AND PROCESSORS (ASAP), 2012 IEEE 23RD INTERNATIONAL CONFERENCE ON, IEEE, 9 juillet 2012 (2012-07-09), pages 173-176, XP032473234, DOI: 10.1109/ASAP.2012.23 ISBN: 978-1-4673-2243-0**
• **MICHAEL BEYER ET AL: "Static Analysis of Run-Time Modes in Synchronous Process Network", 27 juin 2011 (2011-06-27), PERSPECTIVES OF SYSTEMS INFORMATICS, SPRINGER BERLIN HEIDELBERG, BERLIN, HEIDELBERG, PAGE(S) 55 - 67, XP019177337, ISBN: 978-3-642-29708-3 le document en entier**

**Description**

La présente invention concerne un procédé de synthèse automatique de circuits comprenant une étape de compilation d'un programme logiciel en un réseau de processus réguliers interconnectés à l'aide de canaux, selon lequel chaque canal est une mémoire physique adressable, chacun desdits processus applique, lors de chaque itération d'un domaine d'itérations qui lui est associé, au moins une lecture d'une donnée dans un canal et/ou une écriture d'une donnée dans un canal, et une fonction d'ordonnancement fournit, pour chaque valeur d'itération de chaque processus, une position d'exécution du processus sélectionnée dans un ensemble temporellement ordonné de positions d'exécution.

De tels procédés de synthèse de circuits, ou HLS, (en anglais « high-level synthesis »), sont utilisés pour générer automatiquement (ou compiler) un bloc de circuits électroniques à partir d'une description algorithmique (haut niveau telle que le langage C ou Matlab, Alpha) du calcul à effectuer par le circuit (cf. des outils tels que SpecC, HardwareC, HandelC, BashC, TransmogrifierC, CyberC, CatapultC). Les algorithmes concernés sont divers, par exemple des algorithmes de traitement du signal.

Le circuit doit être le plus efficace possible tout en utilisant au mieux les ressources disponibles. Les performances des blocs de circuits générés sont ainsi mesurées notamment par la vitesse de traitement des données fournies en entrée, par la consommation énergétique, la surface de silicium occupée, unités LUT sur FPGA, accès mémoire etc.

Une augmentation des performances est obtenue en divisant le traitement à effectuer en tâches à réaliser en parallèle. La plupart du temps, les tâches ne sont pas totalement indépendantes, et doivent communiquer (écrire/lire) des résultats intermédiaires entre elles, ce qui pose notamment le problème de la synchronisation des tâches entre elles.

Le découpage en tâches parallèles et la production des synchronisations nécessitent un ordonnancement à grain fin du calcul, c'est-à-dire une réorganisation de l'ordre d'exécution des opérations de l'algorithme. Pour être correct, un ordonnancement doit respecter les dépendances de données entre opérations, pour assurer, par exemple, qu'une donnée est produite avant d'être lue.

La plupart des approches existantes s'appuient sur une représentation de type CDFG (Control/Data Flow Graph), qui expriment des dépendances entre constructions syntaxiques, c'est-à-dire entre paquets d'opérations, ce qui mène à une sur-approximation grossière des dépendances telle qu'un ordonnancement intéressant ne peut être trouvé.

Les réseaux de processus sont des modèles d'exécution qui expriment naturellement le parallélisme d'un calcul. A ce titre, ils sont utilisés pour représenter des systèmes parallèles, et ces traductions de systèmes parallèles en réseaux de processus permettent d'étudier, analyser et mesurer différentes problématiques liées au parallélisme (ordonnancement, équilibrage de charge, allocation, checkpointing, consommation, etc).

Les réseaux de processus constituent en outre une représentation intermédiaire naturelle pour un dispositif de synthèse automatique de circuits, dans lequel un bloc « Front-End » extrait le parallélisme et produit un réseau de processus, et un bloc « Back-End » compile le réseau de processus vers l'architecture cible.

Si de nombreuses avancées en termes de performances ont été réalisées sur les aspects back-end (construction des pipelines, placement/routage), les aspects front-end restent encore rudimentaires. La publication "Enabling Automatic Pipeline Utilization Improvement in Polyhedral Process Network Implementations" par Sven Van Astregt et Bart Kienhuis APPLICATION-SPECIFIC SYSTEMS, ARCHITECTURES AND PROCESSORS (ASAP), 2012 IEEE 23RD INTERNATIONAL CONFERENCE ON, IEEE, 9 juillet 2012 (2012-07-09), pages 173-176, XP032473234,DOI: 10.1109/ASAP.2012.23ISBN: 978-1-4673-2243-0, divulgue un procédé de synthèse de circuit de l'art antérieur jugé pertinent car il utilise une approche basée sur un réseau de processus.

Il est ainsi souhaitable d'augmenter encore les performances des blocs de circuits générés automatiquement. L'invention est définie par les revendications indépendantes 1, 6 et 11.

A cet effet, suivant un premier aspect, l'invention propose un procédé de synthèse automatique de circuits du type précité caractérisé en ce qu'il comprend les étapes suivantes, lors de l'étape de compilation, pour chacun desdits canaux :

un unique processus, dit processus producteur, est autorisé à écrire des données dans le canal et un unique processus, dit processus consommateur, est autorisé à lire des données dans ledit canal ; et une unité de synchronisation est associée audit canal, et telle qu'elle collecte, préalablement au lancement de chaque nouvelle itération par le processus producteur du canal, la valeur de ladite nouvelle itération du processus producteur, et collecte, préalablement au lancement de chaque nouvelle itération par le processus consommateur du canal, la valeur d'itération du processus consommateur ; ladite unité de synchronisation, suite à la collecte de la valeur d'une nouvelle itération du processus producteur, respectivement consommateur, autorisant ou gelant la mise en oeuvre de ladite nouvelle itération dudit processus producteur, respectivement consommateur, en fonction d'une comparaison d'une position d'exécution déterminée en fonction de la valeur de nouvelle itération collectée du processus producteur, respectivement consommateur, et d'une position d'exécution déterminée en fonction de la dernière valeur d'itération collectée du processus consommateur, respectivement producteur.

Un tel procédé permet de générer rapidement et de manière automatique des circuits offrant de grandes performances en terme de vitesse de calcul et de volume occupé par le circuit.

Dans des modes de réalisation, le procédé de synthèse automatique de circuit suivant l'invention comporte en outre une ou plusieurs des caractéristiques suivantes :

- ladite unité de synchronisation est telle qu'elle pilote le fonctionnement du processus producteur dudit canal en mettant en oeuvre les étapes suivantes suite à la collecte de la valeur d'une nouvelle itération dudit processus producteur :

  - l'unité de synchronisation compare la nouvelle position d'exécution de ladite valeur collectée, à la position d'exécution de la dernière valeur d'itération du processus consommateur collectée ; et
  - ladite unité de synchronisation gèle la mise en oeuvre par le processus producteur de cette nouvelle itération si la position d'exécution de cette nouvelle itération est postérieure à la position d'exécution de la dernière valeur d'itération collectée du processus consommateur, le gel étant maintenu par l'unité de synchronisation jusqu'à la collecte d'une future valeur d'itération du processus consommateur telle que la position d'exécution de cette future valeur d'itération soit postérieure à ladite position d'exécution de la nouvelle itération du processus consommateur ;

- ladite unité de synchronisation est telle qu'elle pilote le fonctionnement du processus consommateur dudit canal en mettant en oeuvre les étapes suivantes suite à la collecte de la valeur d'une nouvelle itération dudit processus consommateur :

  - l'unité de synchronisation détermine la position d'exécution de celle des valeurs d'itération du processus producteur qui donne lieu à l'écriture dans ledit canal (c) de la donnée qui doit être lue par le processus consommateur lors de cette nouvelle itération ; et
  - ladite unité de synchronisation gèle la mise en oeuvre par le processus consommateur de sa nouvelle itération si la position d'exécution déterminée est postérieure ou égale à la position d'exécution de la dernière valeur d'itération collectée du processus producteur, le gel étant maintenu par l'unité de synchronisation jusqu'à la collecte d'une future valeur d'itération du processus producteur telle que la position d'exécution de cette future valeur d'itération soit supérieure strictement à ladite position d'exécution déterminée.

- le processus consommateur ou producteur de chaque canal après la fin d'une précédente itération dudit processus et préalablement au lancement de la nouvelle itération succédant à la précédente itération, délivre à l'unité de synchronisation du canal, la valeur d'itération de la nouvelle itération du processus, et met en oeuvre cette nouvelle itération du processus en fonction d'une commande de pilotage de l'unité de supervision indiquant un gel ou une autorisation ;
- le processus consommateur du canal après la fin d'une précédente itération dudit processus et préalablement au lancement de la nouvelle itération succédant à la précédente itération, délivre en outre à l'unité de synchronisation du canal, ladite valeur d'itération du processus producteur qui donne lieu à l'écriture dans ledit canal de la donnée qui doit être lue par le processus consommateur lors de cette nouvelle itération.

Suivant un deuxième aspect, la présente invention propose un dispositif de synthèse automatique de circuits adapté pour effectuer une compilation d'un programme logiciel en générant un réseau de processus réguliers interconnectés à l'aide de canaux, dans lequel chaque canal est une mémoire physique adressable, chacun desdits processus étant adapté pour appliquer, lors de chaque itération d'un domaine d'itérations qui lui est associé, au moins une lecture d'une donnée dans un canal et/ou une écriture d'une donnée dans un canal, et une fonction d'ordonnancement étant adaptée pour fournir, pour chaque valeur d'itération de chaque processus, une position d'exécution du processus sélectionnée dans un ensemble temporellement ordonné de positions d'exécution ; ledit dispositif de synthèse de circuits étant caractérisé en ce qu'il est adapté pour lors de ladite compilation, générer et associer à chacun desdits canaux : un unique processus, dit processus producteur, autorisé à écrire des données dans le canal et un unique processus, dit processus consommateur, autorisé à lire des données dans ledit canal ; et une unité de synchronisation associée audit canal et adaptée pour collecter, préalablement au lancement de chaque nouvelle itération par le processus producteur du canal, la valeur de ladite nouvelle itération du processus producteur, et collecter, préalablement au lancement de chaque nouvelle itération par le processus consommateur du canal, la valeur d'itération du processus consommateur ; ladite unité de synchronisation, suite à la collecte de la valeur d'une nouvelle itération du processus producteur, respectivement consommateur, étant adaptée pour autoriser ou geler la mise en oeuvre de ladite nouvelle itération dudit processus producteur, respectivement consommateur, en fonction d'une comparaison d'une position d'exécution déterminée en fonction de la valeur de nouvelle itération collectée du processus producteur, respectivement consommateur, et d'une position d'exécution déterminée en fonction de la dernière valeur d'itération collectée du processus consommateur, respectivement producteur.

Suivant un troisième aspect, la présente invention propose un circuit synthétisé par exemple suite à la mise en oeuvre d'un procédé de synthèse automatique de circuit selon le premier aspect de l'invention, comprenant un réseau de processus réguliers interconnectés à l'aide de canaux, dans lequel chaque canal est une mémoire physique adressable, chacun desdits processus étant adapté pour appliquer, lors de chaque itération d'un domaine d'itérations qui lui est associé, au moins une lecture d'une donnée dans un canal et/ou une écriture d'une donnée dans un canal, et une fonction d'ordonnancement étant adaptée pour fournir, pour chaque valeur d'itération de chaque processus, une position d'exécution du processus sélectionnée dans un ensemble temporellement ordonné de positions d'exécution ;
ledit circuit étant caractérisé en ce qu'il comprend :

un unique processus, dit processus producteur, associé à chaque canal et autorisé à écrire des données dans le canal et un unique processus, dit processus consommateur, associé à chaque canal et autorisé à lire des données dans ledit canal ; et
une unité de synchronisation associée audit canal et adaptée pour collecter, préalablement au lancement de chaque nouvelle itération par le processus producteur du canal, la valeur de ladite nouvelle itération du processus producteur, et collecter, préalablement au lancement de chaque nouvelle itération par le processus consommateur du canal, la valeur d'itération du processus consommateur ; ladite unité de synchronisation, suite à la collecte de la valeur d'une nouvelle itération du processus producteur, respectivement consommateur, étant adaptée pour autoriser ou geler la mise en oeuvre de ladite nouvelle itération dudit processus producteur, respectivement consommateur, en fonction d'une comparaison d'une position d'exécution déterminée en fonction de la valeur de nouvelle itération collectée du processus producteur, respectivement consommateur, et d'une position d'exécution déterminée en fonction de la dernière valeur d'itération collectée du processus consommateur, respectivement producteur.

Ces caractéristiques et avantages de l'invention apparaîtront à la lecture de la description qui va suivre, donnée uniquement à titre d'exemple, et faite en référence aux dessins annexés, sur lesquels :

- la figure 1 représente un dispositif de synthèse automatique de circuits dans un mode de réalisation de l'invention ;
- la figure 2 illustre les domaines d'itération et de dépendances du programme nommé Prog ;
- la figure 3 illustre l'ordre d'exécution du programme Prog ;
- la figure 4 est une vue de processus, multiplexeurs d'entrée, démultiplexeurs de sortie, canaux mis en oeuvre dans la génération automatique du bloc de circuits exécutant la programme Prog ;
- la figure 5 est une vue représentant deux processus du programme Prog, du canal entre ces deux processus et de l'unité de synchronisation associée au canal.

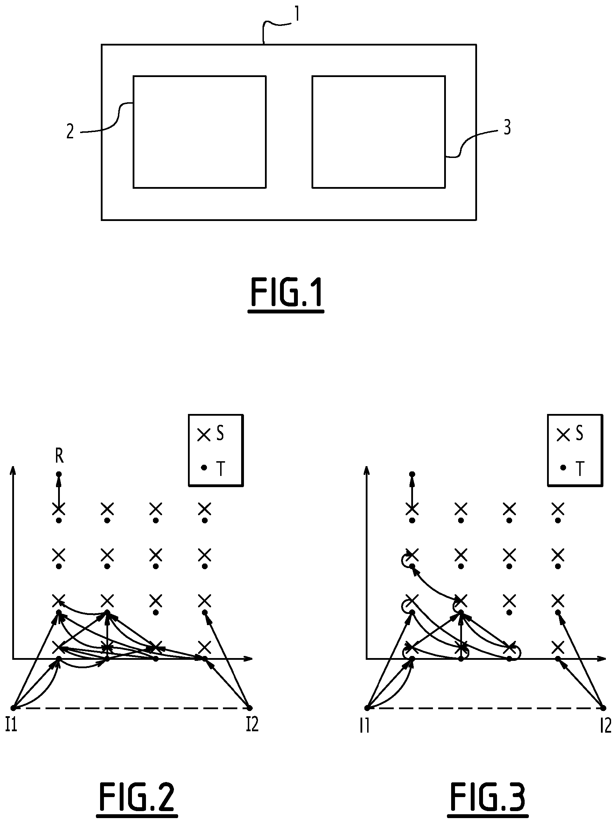

La figure 1 est une vue d'un dispositif 1 de synthèse automatique de circuits hautniveau dans un mode de réalisation de l'invention. Ce dispositif 1 comporte un bloc 2, dit « Front-End » et un bloc 3, dit « Back-End ».

Le bloc « Front-End » 2 analyse la description algorithmique d'un programme fourni en entrée du dispositif 1 pour en extraire le parallélisme et il produit un réseau de processus en tant que représentation intermédiaire du circuit correspondant.

Le bloc « Back-End » 3 transforme la représentation intermédiaire du circuit produite par le bloc « Front-End » 2 en circuit physique.

Ci-après des notions et traitements utilisés dans les dispositifs de synthèse automatique de circuits haut niveau, et également dans le bloc « Front-End » 2 selon l'invention sont tout d'abord rappelés.

## Notions et traitements

### Modèle polyédrique

Le modèle polyédrique est un outil d'analyses et d'optimisations des programmes d'ordinateur à contrôle statique. Les programmes à contrôle statique ne manipulent que des tableaux statiques et des variables de type simple (pas de pointeurs) et dont le contrôle est limité aux boucles « for » et « if ». Une caractéristique essentielle est que les fonctions d'indice des tableaux, les bornes des boucles et les tests des « if » sont des fonctions affines des compteurs des boucles « for » englobantes.

Le vecteur d'itération $\vec{i}$ d'une affectation S est formé des compteurs des boucles qui l'englobent. L'instance d'exécution $(S, \vec{i})$ est appelée opération. Les opérations sont les unités de base des analyses polyédriques. Le domaine d'itération d'une affectation est l'ensemble de tous ses vecteurs d'itération au cours de l'exécution. Sous ces restrictions (boucles « for », « if », contraintes affines), le domaine d'itération d'une affectation est exactement un polyèdre convexe, dont la forme ne dépend pas des entrées de l'affectation. On peut alors le calculer statiquement, et appliquer diverses opérations polyédriques (opérations géométriques, optimisation linéaire, comptage, etc.) pour construire des analyses statiques et transformations de programmes.

Ci-après, on distinguera dans chaque opération W = f ($R_1$, ..., $R_n$) les lectures ($R_1$, ..., $R_n$) et écritures (W). Pour un programme à contrôle statique P, on note $\Omega(P)$ l'ensemble des opérations élémentaires ainsi obtenu. On note $p_{seq}$ l'ordre d'exécution séquentiel sur $\Omega(P)$. On convient que les lectures $R_i$ d'une opération sont exécutées avant l'écriture : $R_i <_{seq} W, \forall i$. Enfin, on note M(P) l'ensemble des emplacements mémoire accédés par chaque opération élémentaire X E $\Omega(P)$. On note $\mu(X)$ l'emplacement accédé (en lecture ou en écriture) par X, $\mu : \Omega(P) \to M(P)$.

Par commodité, dans toute la suite, on appellera opération une opération élémentaire.

## Dépendances, ordonnancement

Il existe une dépendance X -> Y entre deux opérations X, Y $\in \Omega$ (P) lorsque X s'exécute avantY(X $<_{seq}$ Y)) et lorsque X et Y accèdent au même emplacement mémoire ($\mu(X) = \mu(Y)$). Selon la nature de X et de Y (lecture ou écriture), on parle de dépendance de flot (W puis R), anti (R puis W) ou sortie (W puis W). Les dépendances anti et sortie n'expriment que des conflits d'accès à la mémoire et peuvent être supprimés en modifiant l'utilisation de la mémoire En réalité, seules les dépendances de flot comptent, qui expriment le calcul réalisé par le programme. Plus précisément, on s'intéresse aux dépendances de flot W -> R ou W est la dernière écriture de $\mu(R)$ qui précède R, autrement dit le W qui définit la valeur lue par R. Ce W, qui est unique, est appelé source de R. On le note s(R).

On a :
$$s(R) = \max_{<_{seq}} \{W \in \Omega(P), \mu(W) = \mu(R) \wedge W \prec_{seq} R\}$$
, l'opérateur $\Lambda$ signifiant « et ».

Un ordonnancement est une application $\theta$ qui associe à chaque opération du programme une date d'exécution, qui appartient à un ensemble totalement ordonné, $\theta : \Omega$ (P) -> (T, <<).

La plupart des transformations de programmes (optimisations etc.) peuvent s'écrire avec une fonction d'ordonnancement. Le modèle polyédrique fournit des techniques pour calculer des ordonnancements affines $\theta(S,\vec{i}) = A\vec{i} + \vec{b}$ $\in (N^P, <<)$, où << désigne l'ordre lexicographique. Un ordonnancement est correct s'il respecte la causalité des dépendances : i.e s'il existe la dépendance X -> Y entre deux opérations X, Y => $\theta(X) << \theta(Y)$, i.e. l'ordre d'exécution de X est antérieur à celui de Y. L'ordre d'exécution induit par $\theta$ est noté $<_\theta$. On définit $s_\theta$ en remplaçant mutatis mutandis $<_{seq}$ par $<_\theta$ dans la relation relative à s(R) indiquée ci-dessus.

A titre d'exemple, considérons le programme Prog suivant exprimé en langage de haut niveau :

```
I₁ : a[0] = 0;
I₂ : a[N-1] = 0;
for(t=0; t ≤ K-1; t++)
  {
   for(i=1; i ≤  N-2; i++)
S :   b[i] = a[i-1] + a[i] + a[i+1];
   for(i=1; i ≤  N-2; i++)
T :   a[i] = b[i];
  }
R : result = a[1];
```

Ce programme Prog est un programme Jacobi 1D à contrôle statique qui effectue un calcul de relaxation binomiale itératif. Les bords du tableau a sont initialisés (affectations I1 et I2), ensuite, on calcule itérativement une moyenne sur chaque fenêtre de trois cases (affectations S et T). Enfin, on récupère le résultat (affectation R).

Les domaines d'itération des affectations sont donnés en représentés en figure 2. Les domaines des affectations $I_1$, $I_2$ et R sont réduits à un point. Les domaines des affectations S et T sont des rectangles, qu'on superpose ici pour faciliter la présentation. Les points noirs représentent les itérations de S, et les croix représentent les itérations de T.

Ce programme comporte tous les types de dépendances, dont quelques instances sont représentées par des flèches sur le dessin.

- Dépendances de flot : ($I_1$, ) -> (S, t,), ($I_2$,) -> (S, t, N - 2), (S, t, i) -> (T, t, i), (T, t, i) -> (S, t + 1, i -1), (T, t, i) -> (S, t + 1, i), (T, t, i) -> (S, t + 1, i + 1), (T, K - 1,1) - > (R,).
- Dépendances anti (en pointillés) : (S, t, i) -> (T, t, i-1), (S, t, i) -> (T, t, i), (S, t, i) -> (T,t,i+1), (T, t, i) -> (S,t+1 ,i)

- Dépendances de sortie : (S, t, i) -> (S, t+1, i) (T, T-1,1) -> (R, ), toutes ces dépendances sont incluses dans les dépendances de flot, elles ne sont donc pas représentées.

Un ordonnancement valide est $\theta(\text{I1}, ) = \theta(\text{I2}, ) = (0)$, $\theta(S, t, i) = (1, 2t+i, t, 0)$, $\theta(T, t, i) = (1, 2t + i + 1, t, 1)$, $\theta(R, ) = (2)$.

L'ordre d'exécution correspondant est le suivant. On exécute d'abord I1 et I2 en même temps. Ensuite, on exécute les instances de S et T de façon entrelacée, comme indiqué sur le dessin. Enfin, on exécute R.

Cet ordonnancement est valide, en ce sens qu'il satisfait bien toutes les dépendances. Par exemple, la première dépendance anti est respectée puisque $\theta(S,t,i)=(1,2t+i,t,0)<<\theta(T,t,i-1)=(1,2t+i-1+1, t, 1) = (1,2t + i, t, 1)$.

## Allocation mémoire, assignation unique

Une allocation mémoire est une application $\sigma$ qui associe à chaque emplacement mémoire $m \in M(P)$ adressé par P, un emplacement alternatif $\sigma(m)$ dans un nouvel ensemble d'emplacement mémoire M', $\sigma : M(P) -> M'$. Etant fixé un ordonnancement $\theta$, deux emplacements mémoire m et m' $\in M(P)$ $\theta$-interfèrent s'il existe $W_1, W_2, R_1, R_2 \in M(P)$ avec $\mu(W_1) = \mu(R_1) = m$, $\mu(W_2) = \mu(R_2) = m'$, $\theta(W1) << \theta(R2)$, et $\theta(W2) << \theta(R1)$. On note alors $m><_\theta m'$. Une allocation mémoire $\sigma$ est $\theta$-correcte si: $m\rhd\lhd_\theta m'\Rightarrow\sigma(m)\neq\sigma(m')$

Un programme transformé est entièrement décrit par la donnée: (i) des opérations $\Omega(P)$ du programme P, d'un ordonnancement valide $\theta$, et d'une allocation $\theta$-correcte $\sigma : (\Omega(P), \theta, \sigma)$. Le programme initial peut s'écrire $(\Omega(P), \theta_{seq}, \text{Id})$, et on a l'équivalence de calcul : $(\Omega(P), \theta_{seq}, \text{Id}) = (\Omega(P), \theta, \sigma)$, Id étant l'allocation initiale des données.

Un programme est en assignation unique si chaque opération d'écriture écrit un emplacement mémoire différent, autrement dit si pour $W_1, W_2 \varepsilon \Omega(P)$, $\sigma(W_1) = \sigma(W_2) => W_1 = W_2$. Pour passer un programme en assignation unique, on se sert de la fonction source s pour lire les bons emplacements On forme M' = {W, W $\in \Omega(P)$} et on définit $\sigma$ par $\sigma(W) = W$ pour chaque écriture W de $\Omega(P)$ et $\sigma(R) = s(R)$ pour chaque lecture. Le programme transformé $(\Omega(P), \theta, \sigma)$ est alors en assignation unique.

A titre d'exemple, pour passer le programme Prog en assignation unique, on commence par calculer la fonction source s(.).

- $s((\text{I}_1,) : a[0]) = a[0]$, la source de la lecture a[0] de l'opération (I1,) n'existe pas dans le programme, on garde donc la valeur en entrée de a[0].
- $s((\text{I}_2,) : a[N -1]) = a[N -1]$, pour les mêmes raisons.
- Pour les lectures de (S, t, i), on obtient les sources suivantes :

$$s((S,t,i) : a[i-1]) = \begin{cases} i = 1 : (I_1) \\ i \geq 2 \wedge t = 0 : a[i-1] \\ i \geq 2 \wedge t \geq 1 : T[t-1][i-1] \end{cases}$$

$$s((S,t,i) : a[i]) = \begin{cases} t = 0 : a[i] \\ t \geq 1 : T[t-1][i] \end{cases}$$

$$s((S,t,i) : a[i+1]) = \begin{cases} i = N - 2 : (I_2) \\ i \leq N - 2 \wedge t = 0 : a[i+1] \\ i \leq N - 2 \wedge t \geq 1 : T[t-1][i+1] \end{cases}$$

Sur les bords (i = 1 ou i = N - 2), la source est donnée par une affectation d'initialisation ($I_1$ ou $I_2$). Quand t = 0, la source est la valeur initiale du tableau (comme au premier item). Autrement, la valeur est produite par une instance de T ((T, t - 1, i -1), ou (T, t-1, i) ou (T, t -1, i + 1)).

En appliquant l'assignation unique au programme Prog, on obtient alors les lectures du programme Prog en assignation unique, où les lectures sont totalement expansées :

```
I₁ : I₁ = 0;
I₂ : I₂ = 0;
    for(t=0; t ≤ K-1; t++)
    {
      for(i=1; i ≤ N-2; i++)
S :     S[t][i] =                              <--b[i] =a[i-1] + a[i] + a[i+1];
        (i = 1 ? I₁ : (t=0 ? a[i-1] : T[t-1][i-1])) +
        (t = 0 ? a[i] : T[t-1][i]) +
        (i = N - 2 ? I₂ : (t=0 ? a[i+1] : T[t-1][i+1]));
      for(i=1; i ≤ N-2; i++)
T :     T[t][i] = S[t][i];                     <--a[i] = b[i];
    }
R : R = T[K-1][1];
```

Tel quel (avant avoir appliqué l'allocation $(t, i) \to (t\%1, i\%1)$ à S), le programme ne comporte plus que des dépendances de flot, et peut donc être ordonnancé avec $\theta(S, t, i) = (1, t + i, t, 0)$, $\theta(T), t, i) = (1, t + i, t, 1)$. L'ordonnancement de $I_1$, $I_2$ et R reste inchangé.

L'ordre d'exécution est décrit sur la figure 3.

Les intervalles de vie des cases S[t][i] sont disjoints, et donc, on peut appliquer à S l'allocation $\sigma(S[t][i]) = S'[t\%1][i\%1]$. Ci-après est décrit le stade de transformation du programme Prog après l'allocation mémoire sans suivre l'ordre de $\theta$) :

```
I₁ : I₁ = 0;
I₂ : I₂ = 0;
    for(t=0; t ≤ K-1; t++)
    {
      for(i=1; i ≤ N-2; i++)
S :  S[t%1][i] =


      (i = 1 ? I₁ : (t=0 ? a[i-1] : T[(t-1)%1][i-1])) +
      (t = 0 ? a[i] : T[t-1][i]) +
      (i = N - 2 ? I₂ : (t=0 ? a[i+1] : T[(t-1)%1][i+1]));
      for(i=1; i ≤ N-2; i++)
T :   T[t%1][i] = S[t%1][i];
    }
R : R = T[(K-1)%1][1];
```

Seule une dimension de T est active. La fonction d'allocation (donc l'espace mémoire utilisé) dépend de l'ordonnancement choisi.

**Réseaux de processus réguliers**

Un réseau de processus réguliers R est la donnée des éléments suivants :

- P, un ensemble de processus.
- Cens = $\{C_1, ... C_n\}$, un ensemble de mémoires physiques appelées canaux ; chaque canal $C_j$, j = 1 à n, est une mémoire tampon adressable. Les canaux sont découpés en sections, nommées cases.
- Un ensemble de connexions de P x M x P.
- Pour chaque canal $C \in$ Cens, l'historique des écritures $w(C) = W_1^C, ..., W_p^C$ et l'historique des lectures $R(C) = R_1^C, ... , R_p^C$ sont invariants. Cette contrainte implique que la trace d'exécution de chaque processus est fixe. En particulier, les processus peuvent être décrits, mais pas seulement, par des programmes à contrôle statique.
- Un ordre de précédence entre écritures et lectures $<_{prec} \subset W(C) \times R(R)$. $<_{prec}$ est étendu pour exprimer l'ordre séquentiel des écritures ($W_i^C <_{seq} W_j^C$ si i < j) et des lectures ($R_i^c -<_{seq} R_j^C$ si i < j) sur chaque canal C. Dans la

suite, on note $\Omega(R)$ l'ensemble des opérations exécutées par le réseau R, $\Omega(R) = \cup_{C \in Cens} R(C) \cup W(C)$.

Un ordonnancement $\theta_{obs}$ des opérations de R est observable s'il décrit une exécution possible des opérations de R, autrement dit si pour X, Y $\in \Omega(R)$, X $\prec_{prec}$ Y => $\theta_{obs}(X) \ll \theta_{obs}(Y)$.

La compilation d'un programme P à contrôle statique en réseau de processus réguliers est la donnée des éléments suivants :

- Un placement $\Pi : \Omega(P) \rightarrow P$
- Une allocation des canaux $\sigma : \Omega(P) \rightarrow \cup_{Ci \in C} C_i$
- Un ensemble de synchronisations qui garantissent un ordre de précédence $\prec synchro \subset \Omega(P) \times \Omega(P)$ total sur chaque processus $\Pi(X) = \Pi(Y) \Rightarrow X \prec_{synchro} Y$ ou $Y \prec_{prec} X$ et le respect des dépendances de flot $W = s(R) \Rightarrow W \prec_{préc} R$.

Chaque affectation du programme P donne lieu à un processus.

Un réseau est partiellement équivalent à P si toutes ses exécutions qui terminent produisent le même calcul que P, c'est à dire si tous les ordonnancements observables dans R totalement définis sur $\Omega(R)$ sont des ordonnancements corrects de P. De plus, si le réseau est garanti sans interblocage, on dit qu'il est équivalent à P et que la compilation est correcte.

### Réseaux de processus DPN et compilation selon l'invention

Un procédé et un dispositif de synthèse automatique de circuit selon l'invention utilise dans le traitement mis en oeuvre par le bloc 2 « Front-End » un réseau de processus particuliers, dit DPN (en anglais, « Data-aware process network »).

Le bloc « Front-End » 2 effectue en effet une compilation d'un programme à contrôle statique qui lui est fourni en entrée, en réseaux de processus DPN.

Un DPN est un réseau de processus régulier qui vérifie les conditions suivantes :

- Chaque canal admet un unique processus source (i.e. un unique processus autorisé à écrire dans le canal) et un unique processus destination (i.e. un unique processus autorisé à lire dans le canal ; dans un mode de réalisation, il existe même un seul port d'entrée d'un unique processus destination).
- Les canaux sont des mémoires bloquantes en écriture et en lecture ; i.e. ce sont des mémoires à accès aléatoire en lecture et écriture telles qu'un processus ne peut y écrire si le contenu alors présent n'a pas été lu et inversement on ne peut les lire tant que le contenu à lire n'a pas été écrit.

Un schéma de compilation ($\Pi$, $\sigma$, $\prec_{prec}$) d'un programme à contrôle statique P vers un DPN doit vérifier les conditions suivantes:

- Pour chaque lecture dans un canal, la source est bien écrite dans le même canal: si ($P_1$, C, $P_2$) est une connexion de $P_1$ vers $P_2$ en passant par le canal C, alors $\Pi(R) = P2 \wedge \sigma(R)$ e $C \Rightarrow \Pi(s(R)) = P_1 \wedge \sigma(s(R)) \wedge C$.
- On choisit un ordonnancement correct $\theta$ dont l'ordre induit sur $\Omega(P)$ est total, et on choisit une allocation $\sigma$ qui est $\theta$-correcte.
- L'ordre de précédence est total sur chaque processus, et non défini partout ailleurs,

$$\prec_{prec} = \prec_{\theta} \bigcap \{(X,Y), \Pi(X) = \Pi(Y)\}.$$

- Pour chaque écriture W, la dernière lecture $d(W) = \max_{\prec_{prec}} \{R, s(R) = W\}$ libère la case écrite par W, $\sigma(W)$. La case $\sigma(W)$ doit alors être à nouveau écrite pour pouvoir être lue.

Une telle compilation est correcte : le DPN obtenu est partiellement équivalent au programme original P et il ne se produit jamais d'interblocage.

Un DPN simple comporte trois types de processus:

- Des processus LD, qui lisent les données entrantes dans la mémoire centrale.
- Des processus ST, qui écrivent le résultat final du calcul en mémoire centrale.
- Des processus Cal en charge du calcul à proprement parler.

On considère un programme P à traduire en DPN par le bloc « Front-End » 2 et un ordonnancement $\theta$ valide.

Afin de construire facilement les processus LD et ST, le bloc « Front-End » 2 ajoute au programme P, pour chaque tableau de données a lu en entrée dans la mémoire principale distante, la famille d'opérations suivante :
$\vec{i} \in \Omega : a[\vec{i}] = 0 ; //(LD_a, \vec{i})$, où $\Omega$ est l'ensemble des indices du tableau a.

Pour chaque tableau écrit b, le bloc « Front-End » 2 ajoute au programme la famille d'opérations suivante, où d est une variable scalaire quelconque:
$\vec{i} \in \Omega : d = b[\vec{i}] ; //(ST_b, \vec{i})$ où $\Omega$ est l'ensemble des indices du tableau b.

On convient que les opérations $LD_a$ sont exécutées tout au début de P, et que les opérations de $ST_b$ sont exécutées tout à la fin de P. Ainsi $(LD_a, \vec{i_1}) \prec_{prec} (S, \vec{i_2}) \prec_{prec} (ST_b, \vec{i_3})$ pour chaque opération originale $(S, \vec{i_2})$ de P. Cette propriété peut être spécifiée avec un ordonnancement multidimensionnel.

Le bloc « Front-End » 2 crée un réseau DPN en plaçant chaque affectation sur un processus différent, P = {S1, ..., $S_n$} (affectations de P), et $\Pi(W) = \Pi(R1) = ... = \Pi(R_n) = S$, où W, R1, ..., Rn sont les opérations réalisées par l'affectation S : W = f(R1, ..., Rn) . En particulier, il est créé un processus $L_{Da}$ par tableau a lu, et un processus $S_{Tb}$ par tableau *b* écrit. La connexion de ces processus aux processus de calcul s'obtient naturellement avec la fonction source s.

Chaque processus est muni par le bloc « Front-End » 2 des éléments suivants:

- *Un port d'entrée* par référence lue par l'affectation implémentée par le processus. Le port d'entrée est un *multiplexeur,* chargé de récupérer la valeur de la référence dans le bon canal.
- *Un port de sortie,* qui émet la valeur calculée par le processus. Le port de sortie est un *démultiplexeur* qui écrit la valeur calculée par le processus dans le bon canal.

Pour construire un DPN, il suffit au bloc « Front-End » 2 de calculer ces éléments, et d'allouer chaque canal (fonction $\sigma$).

**Multiplexage, démultiplexage**

Lors de la compilation d'un programme P, le bloc « Front-End » 2 calcule la fonction source pour chaque lecture.

Pour une opération $(T, \vec{i}) : \vec{i} \in D$ (domaine d'itération de T) : W = f (R1, ..., $R_n$), la source d'une lecture R parmi {R1, ..., Rn} se présente sous la forme :

$$
s((T, \vec{i}) : R) = \begin{cases} \vec{i} \in D_1 : (S_1, u_1(\vec{i})) \\ \ldots \\ \vec{i} \in D_\ell : (S_\ell, u_\ell(\vec{i})) \end{cases}
$$

où les $D_k$ sont des polyèdres convexes fermés, les $u_k$ sont des fonctions affines et les $T_k$ sont des affectations du programme.

Pour chaque couple d'affectations (S, T) telles que *S* écrit un tableau lu par la référence R de T, le bloc « Front-End » 2 crée un canal $C_{S,T,R}$. Si *D* est le domaine d'itération de S, $C_{S,T,R}$ est un tableau de dimension égale à la dimension de D, dim D.

Ces canaux sont ensuite connectés par le bloc « Front-End » 2 aux processus *via* les ports d'entrée et de sortie en procédant de la façon suivante.

Pour chaque affectation T $\in$ {$T_1$, ..., $T_n$}, pour chaque lecture R de T, pour chaque clause $\vec{i} \in D_k : (S_k, u_k(i))$ de la source s((T,i) : R), le bloc « Front-End » 2 effectue les opérations suivantes :

- ajout au port d'entrée correspondant à R d'une connexion au canal $C_{Sk,T,R}$, et on ajoute la clause de multiplexage $\vec{i} \in D_k : C_{SkT,R}[u_k(\vec{i})]$ qui commande la lecture de la case $u_k(\vec{i})$ du canal $C_{Sk,T,R}$ quand l'itération courante vérifie $\vec{i} \in D_k$ ;
- ajout au port de sortie de $S_k$ une connexion vers le canal $C_{Sk,T,R}$, et ajout de la clause de multiplexage $\vec{i} \in u_k(D_k) : C_{Sk,T,R}[\vec{i}]$ qui commande l'écriture de la valeur calculée dans la case $\vec{i}$ (vecteur d'itération courant) du canal $C_{Sk,T,R}$ quand l'itération courante vérifie $\vec{i} \in u_k(D_k)$.

Par construction, chaque canal $C_{Sk,T,R}$ possède bien une unique source ($S_k$) et un seul port d'une unique destination (*T*).

Un multiplexeur pour chaque port d'entrée d'une affectation T est adapté pour déterminer la clause de multiplexage correspondant au vecteur d'itération courant de l'affectation et fournissant le canal pertinent et sa case pour ce vecteur d'itération et pour lire cette case de ce canal.

Un démultiplexeur pour chaque port de sortie d'une affectation S est adapté pour déterminer la clause de multiplexage correspondant au vecteur d'itération courant de l'affectation et fournissant le canal pertinent et sa case pour ce vecteur d'itération, et pour écrire le résultat dans cette case de ce canal.

Ensuite, les processus LD et ST sont connectés au DPN. En effet, lorsque $T_k$ est un processus $LD_a$, il s'agit d'une valeur d'entrée du processus, et la compilation par le bloc Front-End 2 crée naturellement le multiplexage pour récupérer la bonne valeur dans le canal écrit par $LD_a$.

De plus, le multiplexeur d'un processus de sortie $ST_b$ récupère dans ses canaux les valeurs finales pour chaque case de b.

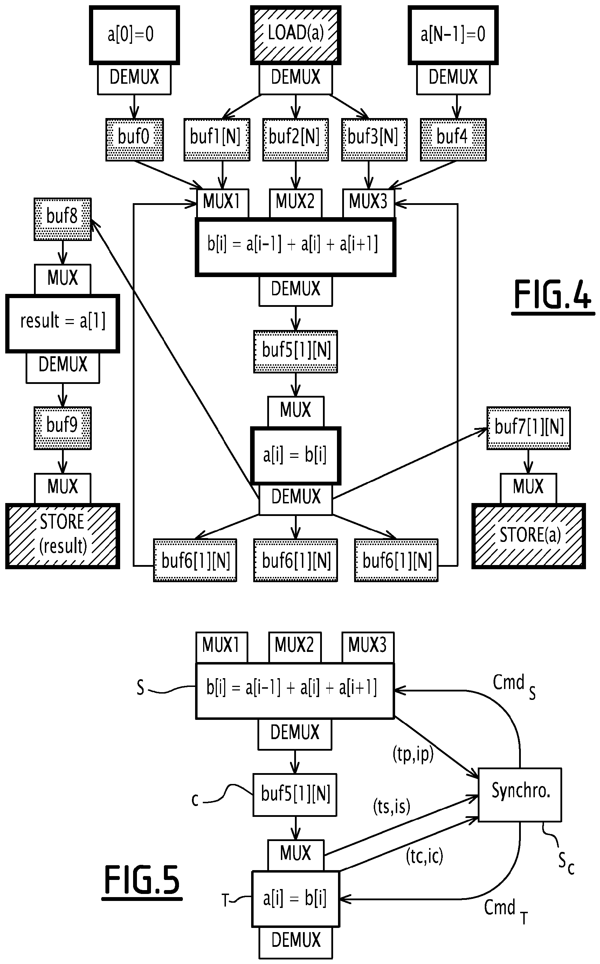

A titre d'illustration, la figure 4 illustre le résultat de la compilation par le bloc « Front-End » 2 du programme Prog. Les processus sont représentés par des boîtes aux contours en trait gras. Les processus de calcul sont représentés par des boîtes aux contours en trait gras sans motif intérieur, les processus $LD_a$ et ST (LOAD et STORE) sont représentés par des boîtes aux contours en trait gras avec un motif intérieur strié. Les canaux sont représentés par des boîtes aux contours en trait fin avec des points en motif intérieur, les multiplexeurs et démultiplexeurs sont représentés en contours en trait fin sans motif intérieur.

Chaque processus de calcul possède un ou plusieurs ports d'entrée. Chaque port d'entrée est disposé entre un multiplexeur qui lui est propre, nommé sur la figure 4 selon les processus « MUX », « MUX1 », « MUX2 », « MUX3 », et le processus.

Le multiplexeur détermine quel est le canal pertinent et la case du canal pour l'itération courante, et lit la donnée dans cette case du canal pertinent.

De même, chaque processus possède un port de sortie, qui transmet le résultat du calcul courant vers un démultiplexeur, nommé sur la figure 4 « DEMUX ». Le démultiplexeur détermine quel est le canal pertinent ou les canaux pertinents, et la case du canal pour l'itération courante de l'affectation et écrit le résultat dans un ou plusieurs canaux.

Par exemple, le processus, dans le programme Prog, calculant l'affectation S correspondant à b[i] = a[i-1] + a[i] + a[i+1], possède trois ports d'entrée, avec les valeurs respectives de a[i - 1], a[i], et a[i + 1]. Pour la lecture de a[i-1], le multiplexeur MUX 1 détermine à l'aide de la fonction source s((S, t, i) : a[i-1]) que quand $i \geq 2 \wedge t = 0$, la source est $(LD_a, i - 1)$, d'où la sélection d'un canal en provenance de LOAD(a). Le démultiplexage correspondant du processus LOAD(a) est donné par $[(t, i) \rightarrow i -1]$ ($i \geq 2$ A $t = 0$) = $i \geq 1$.

Le DPN a été obtenu et opère de façon analogue pour chaque source de chaque lecture de chaque affectation.

Dans la suite, le processus qui exécute l'affectation S sera dénommé « processus S » et le processus qui exécute l'affectation *T* sera dénommé « processus *T* ».

## Allocation des canaux

Le bloc « Front-End » 2 est en outre adapté pour créer, lors de la compilation du réseau DPN pour un programme P, une fonction d'allocation σ pour chaque canal.

σ est utilisée comme fonction d'adressage du canal. Toute requête vers Canal $[\vec{i}]$ accède en réalité à Canal $[\sigma(\vec{i})]$.

L'allocation se présente sous la forme d'une fonction affine modulaire $A\vec{i} \bmod \vec{b}$.

Les coordonnées de $\vec{b}$ correspondent aux tailles des différentes dimensions du canal $C_{Tk,S,Rk}$, qui peut maintenant être effectivement construit par le bloc Front-end 2.

A titre d'illustration relative à la construction d'un réseau DPN pour le programme Prog, pour allouer le canal C entre *S* et *T, avec*

θ(S, t, i) = (t + i, t, 0), θ(T, t, i) = (t + i, t, 1). le Bloc front-end 2 calcule la fonction d'allocation σ(t, i) = (t mod 1, i mod 1), par exemple comme décrit dans « Lattice-Based Array Contraction: From Theory to Practice », Christophe Alias, Fabrice Baray, Alain Darte, Research Report RR2007-44, Laboratoire de l'informatique du Parallélisme, ENS-Lyon, November 2007. En d'autres termes, $C_{S,T,b[i]}$ est un canal à 2 dimensions de taille 1 x 1, qui est dorénavant accédé avec σ.

Il peut être implémenté avec un simple registre.

## Synchronisation des canaux

Dans un réseau DPN selon l'invention, les canaux sont bloquants en lecture et en écriture : une case d'un canal ne peut pas être lue avant d'avoir été écrite (par sa source), et une case ne pas être écrite avant que sa valeur couramment stockée ne soit lue pour la dernière fois.

Les écritures et les lectures dans un canal sont synchronisées, selon l'invention, pour forcer cette propriété.

Le bloc « Front-End » 2 est ainsi adapté pour construire une *unité de synchronisation S<sub>c</sub>,* pour chaque canal c qui relie le port de sortie d'un processus producteur *P* au port d'entrée $R_k$ d'un processus consommateur *C*.

Chaque itération *W* (écriture) du producteur et chaque itération *R* (lecture) du consommateur dans le canal c donnent lieu, préalablement à leur exécution, à la fourniture d'une requête d'exécution soumises à l'unité de synchronisation $S_c$, qui décide d'autoriser ou non leur exécution.

Pour forcer les dépendances de flot, l'unité de synchronisation décide dans un mode de réalisation de l'invention, d'arrêter l'exécution du consommateur si la donnée qu'il veut lire n'est pas encore produite. Et pour forcer les dépendances anti-, l'unité de synchronisation décide, dans un mode de réalisation de l'invention, d'arrêter l'exécution du producteur s'il veut écraser une donnée qui n'a pas encore été lue pour la dernière fois. Notons qu'il n'est pas nécessaire de forcer les dépendances de sortie, toutes les écritures étant exécutées par le producteur dans l'ordre séquentiel de l'ordonnancement.

Ces deux évènements se traduisent de la façon suivante par exemple par l'utilisation par l'unité de synchronisation de la fonction suivante $S_c$ par l'unité de synchronisation, où $X \preceq_\theta Y$ signifie que $\theta(X) \ll \theta(Y)$ (i.e. $\theta(X)$ est antérieur ou égal à $\theta(Y)$) et s() est la fonction source, pour déterminer si la réponse à une requête d'un processus consommateur C est un signal Freeze(C) destiné au processus C ou pour déterminer si la réponse à une requête d'un processus producteur P est un signal Freeze(P) destiné au processus P :

$$S_c(W,R) = \begin{cases} Freeze(C) & si & W \preceq_\theta s(R) \\ Freeze(P) & si & \{R' \in \Omega(P,I), R \prec_\theta R' \prec_\theta W \wedge \sigma_c(R') = \sigma_c(W)\} \neq \emptyset \end{cases}$$

Le signal *Freeze* (*C*) interrompt l'exécution du processus consommateur C, et Freeze (P) celle du producteur P.

Dans un mode de réalisation, un signal *Freeze* existe aussi longtemps que sa condition est vraie. Lorsque sa condition redevient fausse, il cesse d'être émis, et le processus reprend son exécution.

Dans un autre mode de réalisation, un signal Freeze est émis, une fois, en réponse à une requête d'un processus, lorsque la condition testée est vraie. Et lorsque la condition est fausse ou dès qu'elle devient fausse, un signal d'autorisation est émis vers le processus.

La première condition dans la formule de $S_c$ ci-dessus signifie que l'exécution du consommateur est interrompue lorsque la donnée à lire n'est pas encore écrite. Autrement dit, lorsque le producteur P exécute une écriture $W$ qui précède l'écriture de la donnée lue par $R$, $s(R)$.

La deuxième condition signifie que l'exécution du producteur P est interrompue quand il est sur le point d'écraser une donnée qui n'a pas fini d'être lue.

Autrement dit, lorsque le producteur P tente d'écrire une case $\sigma_c(W)$ qui doit encore être lue plus tard par $R'$.

La fonction source $s(R)$ est déjà calculée par le multiplexeur du processus $C$ qui lit le canal $c$.

La condition *Freeze (P)* peut être simplifiée de manière conservative en $R \prec_\theta W$ (en effet, si *Freeze (P)* est vrai, on a nécessairement $R \prec_\theta W$).

*Preuve.* Si Freeze (*P*) est vrai, il existe R" avec $R \prec_\theta R' \prec_\theta W$,. On obtient le résultat par transitivité de $\prec_\theta$,

Ce théorème signifie que chaque fois qu'il faut bloquer le producteur, $R \prec_\theta W$, devient vrai. Par contre, $R \prec_\theta W$, peut continuer à être vrai plusieurs itérations après que la case à écrire ait été libérée par le consommateur bloquant inutilement le producteur. En particulier, quand $d(R') \prec_\theta R \prec_\theta W$, le producteur devra encore attendre que R soit exécuté. Au final, le producteur respectera exactement l'ordonnancement θ spécifié par l'utilisateur, sans "faire de zèle ». Il est donc de la responsabilité de l'utilisateur de fournir l'ordonnancement le plus parallèle possible.

L'unité de synchronisation $S_c$ respecte les dépendances de données et ne produit jamais d'interblocage.

A titre d'illustration, en référence à la figure 5, considérons à nouveau le canal c = $C_{S,T,b[i]}$ entre les processus S *(producteur)* et T *(consommateur)*.

Le processus consommateur T, avant d'entamer chaque nouvelle itération $(t_C, i_C)$, transmet à l'unité de synchronisation du canal c dans lequel son multiplexeur a déterminé qu'il doit lire une référence, une requête d'autorisation d'exécution d'une nouvelle itération, l'identifiant de sa nouvelle itération, $(t_C, i_C)$, ainsi que l'identifiant de l'itération correspondante attendue $(t_S, i_S)$ du processeur producteur S, i.e. qui donne lieu à l'écriture dans le canal c de cette référence. $(t_S, i_S)$ est obtenue par la fonction source s, d'où l'indice 's'. Le processus consommateur n'entame pas cette nouvelle itération tant qu'il n'y a pas été autorisé par l'unité de synchronisation.

Similairement, le processus producteur S, avant d'entamer chaque nouvelle itération $(t_P, i_P)$, transmet à l'unité de synchronisation du canal c dans lequel son démultiplexeur a déterminé qu'il doit écrire un résultat, une requête d'autorisation d'exécution d'une nouvelle itération et l'identifiant de sa nouvelle itération, $(t_P, i_P)$. Le processus producteur n'entame pas cette nouvelle itération tant qu'il n'y a pas été autorisé par l'unité de synchronisation.

Considérons que l'unité de synchronisation vient de recevoir la requête d'autorisation d'exécution d'une nouvelle itération du processus consommateur T, $(t_C, i_C)$, l'identifiant de sa nouvelle itération, $(t_C, i_C)$, et l'identifiant de l'itération correspondante attendue $(t_S, i_S)$ du processeur producteur S.

Si $\theta(S, t_S, i_S) \ll \theta(S, t_P, i_P)$ ,$((t_P, i_P)$ étant le dernier identifiant d'itération du processus producteur S alors transmis par S à l'unité de synchronisation) et θ la fonction d'ordonnancement, l'unité de synchronisation autorise la nouvelle itération $(t_C, i_C)$ du consommateur T. Une commande correspondante $Smd_T$ est alors transmise en réponse par l'unité de synchronisation au processus consommateur T (comme vu précédemment, cette commande est alors un signal d'autorisation ou l'absence d'un signal de type Freeze(C) suivant les modes de réalisation évoqués).

Si au contraire $\theta(S,t_P,i_P)\underset{=}{<<}\theta(S,t_S,i_S)$, et tant que cette dernière expression reste vraie (($t_P$, $i_P$) étant le dernier identifiant d'itération du processus producteur S alors transmis par S à l'unité de synchronisation), l'unité de synchronisation n'autorise pas la nouvelle itération ($t_C$, $i_C$) du consommateur T. Une commande correspondante $Smd_T$ est alors transmise en réponse par l'unité de synchronisation au processus consommateur T (comme vu précédemment, cette commande est alors un signal Freeze(C), continu ou ponctuel suivant les modes de réalisation évoqués).

Considérons à présent que l'unité de synchronisation vient de recevoir la requête d'autorisation d'exécution d'une nouvelle itération du processus producteur S et l'identifiant de sa nouvelle itération, ($t_P$, $i_P$).

Si $\theta(S,t_P,i_P) \underset{=}{<<} \theta(T,t_C,i_C)$ ,(($t_C$, $i_C$) étant le dernier identifiant d'itération du processus consommateur T alors transmis par T à l'unité de synchronisation), l'unité de synchronisation autorise la nouvelle itération ($t_P$, $i_P$) du producteur S. Une commande correspondante $Smd_S$ est alors transmise en réponse par l'unité de synchronisation au processus producteur S (comme vu précédemment, cette commande est alors un signal d'autorisation ou l'absence d'un signal de type Freeze(P) suivant les modes de réalisation évoqués).

Si au contraire $\theta(T,t_C,i_C) << \theta(S,t_P,i_P)$, et tant que cette dernière expression reste vraie, l'unité de synchronisation n'autorise pas la nouvelle itération ($t_P$, $i_P$) du processus producteur S. Une commande correspondante $Smd_S$ est alors transmise en réponse par l'unité de synchronisation au processus consommateur T (comme vu précédemment, cette commande est alors un signal Freeze(P), continu ou ponctuel suivant les modes de réalisation évoqués).

En prenant comme fonction d'ordonnancement celle indiquée dans les exemples précédents relatif à la construction d'un réseau DPN pour le programme Prog, S étant le processus producteur et T étant le processus consommateur, les expressions relatives à Freeze(C) et Freeze(P) indiquée plus haut deviennent :

Freeze(C) si, et tant que, $(t_P + i_P, t_P, 0) \underset{=}{<<} (t_S + i_S, t_S, 0)$
i.e. si et tant que : $(t_P + i_P < t_S + i_S) \vee (t_P + i_P = t_S + i_S \wedge t_P < t_S) \vee (t_P + i_P = t_S + i_S \wedge t_P = t_S)$;
$\vee$ signifiant « OU ».
Freeze(P) si, et tant que, $(t_C + i_C, t_C, 1) << (t_P + i_P, t_P, 0)$
i.e. si et tant que : $(t_C + i_C < t_P + i_P) \vee (t_C + i_C = t_P + i_P \wedge t_C < t_P)$.

Par nature, l'ordre lexicographique (<<) produit des expressions très redondantes, ce qui permet de produire un circuit de test très simple.

On notera que dans d'autres modes de réalisation, des règles de synchronisation autres sont mises en oeuvre par l'unité de synchronisation pour synchroniser entre eux les processus producteur et consommateur associés à un même canal.

Une fois la transformation en représentation intermédiaire DPN ainsi réalisée par le bloc 2 « Front-End » à partir de la représentation algorithmique du programme Prog, cette représentation intermédiaire est fournie au bloc 3 « Back-End ».

De manière connue, le bloc 3 « Back-End » construit matériellement le bloc de circuits électroniques à partir de cette représentation intermédiaire DPN On pourra utiliser, par exemple, un outil de synthèse existant comme C2H, comme décrit dans « Christophe Alias, Alain Darte, and Alexandru Plesco. Optimizing DDR-SDRAM Communications at C-Level for Automatically-Generated Hardware Accelerators. An Expérience with the Altera C2H HLS Tool. In 21st IEEE International Conférence on Application-specific Systems, Architectures and Processors (ASAP'10), Rennes, France, pages 329-332, July 2010. IEEE Computer Society ». Chaque processus, canal, multiplexeur est décrit comme une fonction C2H. Chaque fonction est traduite par C2H dans un module matériel. Les connexions entre les modules sont spécifiées à C2H en utilisant des pragmas de connexion. Chaque connexion sera traduit par C2H dans un bus matériel standard.

Un dispositif de synthèse automatique de circuits selon l'invention permet de générer automatiquement des circuits électroniques réalisant, rapidement et en requérant un volume physique occupé limité, les calculs d'un programme P écrit dans un langage de haut niveau.

Il existe de nombreux modèles d'exécution parallèle sous forme de réseaux de processus (KPN, SDF, etc.). L'invention propose la compilation en réseaux de processus DPN (Data-aware Process Network) selon un modèle d'exécution parallèle adapté aux contraintes matérielles de la synthèse de circuits dans lequel les transferts de données avec une mémoire distante sont explicites. Une telle compilation en DPN est consistante en cela qu'elle transforme un programme séquentiel en un réseau de processus DPN équivalent, garanti sans interblocage. Les entrées/sorties (i.e. les transferts de données avec une mémoire distante) sont explicites et les canaux de communication sont des mémoires tampons beaucoup moins contraignantes que des FIFO, pilotées des unités de synchronisation de performance équivalente.

**Revendications**

1. Procédé de synthèse automatique de circuits comprenant une étape de compilation d'un programme logiciel en un réseau de processus réguliers interconnectés à l'aide de canaux (c), selon lequel chaque canal est une mémoire physique adressable, chacun desdits processus applique, lors de chaque itération d'un domaine d'itérations qui lui est associé, au moins une lecture d'une donnée dans un canal et/ou une écriture d'une donnée dans un canal, et une fonction d'ordonnancement fournit, pour chaque valeur d'itération de chaque processus, une position d'exécution du processus sélectionnée dans un ensemble temporellement ordonné de positions d'exécution ;

   ledit procédé de synthèse de circuits comprenant une étape de transformation dudit réseau de processus compilé en circuit physique et étant **caractérisé en ce qu'**il comprend les étapes suivantes, lors de l'étape de compilation, pour chacun desdits canaux (c) :

   un unique processus, dit processus producteur (S), est autorisé à écrire des données dans le canal (c) et un unique processus, dit processus consommateur (T), est autorisé à lire des données dans ledit canal ; et
   une unité de synchronisation ($S_c$) est associée audit canal, et telle qu'elle collecte, préalablement au lancement de chaque nouvelle itération par le processus producteur du canal, la valeur ($t_p$, $i_p$) de ladite nouvelle itération du processus producteur, et collecte, préalablement au lancement de chaque nouvelle itération par le processus consommateur du canal, la valeur d'itération du processus consommateur (te, ic); ladite unité de synchronisation, suite à la collecte de la valeur d'une nouvelle itération du processus producteur, respectivement consommateur, autorisant ou gelant la mise en oeuvre de ladite nouvelle itération dudit processus producteur, respectivement consommateur, en fonction d'une comparaison d'une position d'exécution déterminée en fonction de la valeur de nouvelle itération collectée du processus producteur, respectivement consommateur, et d'une position d'exécution déterminée en fonction de la dernière valeur d'itération collectée du processus consommateur, respectivement producteur.

2. Procédé de synthèse automatique de circuits selon la revendication 1, selon lequel ladite unité de synchronisation ($S_c$) est telle qu'elle pilote le fonctionnement du processus producteur (S) dudit canal (c) en mettant en oeuvre les étapes suivantes suite à la collecte de la valeur d'une nouvelle itération ($t_p$, $i_p$) dudit processus producteur :

   - l'unité de synchronisation compare la nouvelle position d'exécution ($\theta(t_P, i_P)$) de ladite valeur collectée, à la position d'exécution ($\theta(t_C, i_C)$) de la dernière valeur d'itération du processus consommateur (T) collectée ; et
   - ladite unité de synchronisation gèle la mise en oeuvre par le processus producteur de cette nouvelle itération si la position d'exécution ($\theta(t_P, i_P)$) de cette nouvelle itération est postérieure à la position d'exécution ($\theta(t_C, i_C)$) de la dernière valeur d'itération collectée du processus consommateur, le gel étant maintenu par l'unité de synchronisation jusqu'à la collecte d'une future valeur d'itération du processus consommateur telle que la position d'exécution ($\theta(t_C, ic)$) de cette future valeur d'itération soit postérieure à ladite position d'exécution ($\theta(t_P, i_P)$) de la nouvelle itération du processus consommateur.

3. Procédé de synthèse automatique de circuits selon la revendication 1 ou 2, selon lequel ladite unité de synchronisation ($S_c$) est telle qu'elle pilote le fonctionnement du processus consommateur (T) dudit canal en mettant en oeuvre les étapes suivantes suite à la collecte de la valeur d'une nouvelle itération dudit processus consommateur :

   - l'unité de synchronisation détermine la position d'exécution ($\theta(t_S, i_S)$) de celle des valeurs d'itération du processus producteur (S) qui donne lieu à l'écriture dans ledit canal (c) de la donnée qui doit être lue par le processus consommateur lors de cette nouvelle itération ; et
   - ladite unité de synchronisation gèle la mise en oeuvre par le processus consommateur de sa nouvelle itération si la position d'exécution ($\theta(t_S, i_S)$) déterminée est postérieure ou égale à la position d'exécution ($\theta(t_P, i_P)$) de la dernière valeur d'itération collectée du processus producteur, le gel étant maintenu par l'unité de synchronisation jusqu'à la collecte d'une future valeur d'itération du processus producteur telle que la position d'exécution ($\theta(t_P, i_P)$) de cette future valeur d'itération soit supérieure strictement à ladite position d'exécution ($\theta(t_S, i_S)$) déterminée.

4. Procédé de synthèse automatique de circuits selon l'une des revendications 1 à 3, selon lequel le processus consommateur (T) ou producteur (S) de chaque canal après la fin d'une précédente itération dudit processus et préalablement au lancement de la nouvelle itération succédant à la précédente itération, délivre à l'unité de synchronisation ($S_c$) du canal (c), la valeur d'itération de la nouvelle itération du processus, et met en oeuvre cette nouvelle itération du processus en fonction d'une commande de pilotage de l'unité de supervision indiquant un gel ou une autorisation.

5. Procédé de synthèse de circuits selon la revendication 4, selon lequel le processus consommateur (T) du canal (c), après la fin d'une précédente itération dudit processus et préalablement au lancement de la nouvelle itération succédant à la précédente itération, délivre en outre à l'unité de synchronisation ($S_c$) du canal, ladite valeur d'itération du processus producteur (S) qui donne lieu à l'écriture dans ledit canal de la donnée qui doit être lue par le processus consommateur lors de cette nouvelle itération.

6. Dispositif (1) de synthèse automatique de circuits adapté pour effectuer une compilation d'un programme logiciel en générant un réseau de processus réguliers interconnectés à l'aide de canaux (c), dans lequel chaque canal est une mémoire physique adressable, chacun desdits processus étant adapté pour appliquer, lors de chaque itération d'un domaine d'itérations qui lui est associé, au moins une lecture d'une donnée dans un canal et/ou une écriture d'une donnée dans un canal, et une fonction d'ordonnancement étant adaptée pour fournir, pour chaque valeur d'itération de chaque processus, une position d'exécution du processus sélectionnée dans un ensemble temporellement ordonné de positions d'exécution ;
ledit dispositif de synthèse de circuits étant adapté pour transformer ledit réseau de processus compilé en circuit physique et étant **caractérisé en ce qu'**il est adapté pour lors de ladite compilation, générer et associer à chacun desdits canaux (c) :

   un unique processus, dit processus producteur (S), autorisé à écrire des données dans le canal (c) et un unique processus, dit processus consommateur (T), autorisé à lire des données dans ledit canal ; et
   une unité de synchronisation ($S_c$) associée audit canal et adaptée pour collecter, préalablement au lancement de chaque nouvelle itération par le processus producteur du canal, la valeur ($t_p$, $i_p$) de ladite nouvelle itération du processus producteur, et collecter, préalablement au lancement de chaque nouvelle itération par le processus consommateur du canal, la valeur d'itération du processus consommateur (te, ic) ; ladite unité de synchronisation, suite à la collecte de la valeur d'une nouvelle itération du processus producteur, respectivement consommateur, étant adaptée pour autoriser ou geler la mise en oeuvre de ladite nouvelle itération dudit processus producteur, respectivement consommateur, en fonction d'une comparaison d'une position d'exécution déterminée en fonction de la valeur de nouvelle itération collectée du processus producteur, respectivement consommateur, et d'une position d'exécution déterminée en fonction de la dernière valeur d'itération collectée du processus consommateur, respectivement producteur.

7. Dispositif (1) de synthèse automatique de circuits selon la revendication 6, dans lequel ladite unité de synchronisation ($S_c$) générée est adaptée pour piloter le fonctionnement du processus producteur (S) dudit canal (c) en mettant en oeuvre les étapes suivantes suite à la collecte de la valeur d'une nouvelle itération ($t_p$, $i_p$) dudit processus producteur :

   - comparer la nouvelle position d'exécution ($\theta(t_P, i_P)$) de ladite valeur collectée, à la position d'exécution ($\theta(t_C, ic)$) de la dernière valeur d'itération du processus consommateur (T) collectée ; et
   - geler la mise en oeuvre par le processus producteur de cette nouvelle itération si la position d'exécution ($\theta(t_P, i_P)$) de cette nouvelle itération est postérieure à la position d'exécution ($\theta(t_C, ic)$) de la dernière valeur d'itération collectée du processus consommateur, et maintenir le gel jusqu'à la collecte d'une future valeur d'itération du processus consommateur telle que la position d'exécution ($\theta(t_C, ic)$) de cette future valeur d'itération soit postérieure à ladite position d'exécution ($\theta(t_P, i_P)$) de la nouvelle itération du processus consommateur.

8. Dispositif (1) de synthèse automatique de circuits selon la revendication 6 ou 7, ladite unité de synchronisation ($S_c$) générée est adaptée pour piloter le fonctionnement du processus consommateur (T) dudit canal en mettant en oeuvre les étapes suivantes suite à la collecte de la valeur d'une nouvelle itération dudit processus consommateur :

   - déterminer la position d'exécution ($\theta(t_S, is)$) de celle des valeurs d'itération du processus producteur (S) qui donne lieu à l'écriture dans ledit canal (c) de la donnée qui doit être lue par le processus consommateur lors de cette nouvelle itération, ; et
   - geler la mise en oeuvre par le processus consommateur de sa nouvelle itération si la position d'exécution ($\theta(t_S, is)$) déterminée est postérieure ou égale à la position d'exécution ($\theta(t_P, i_P)$) de la dernière valeur d'itération collectée du processus producteur, et maintenir le gel jusqu'à la collecte d'une future valeur d'itération du processus producteur telle que la position d'exécution ($\theta(t_P, i_P)$) de cette future valeur d'itération soit supérieure strictement à ladite position d'exécution ($\theta(t_S, is)$) déterminée.

9. Dispositif de synthèse automatique de circuits selon l'une des revendications 6 à 8, dans lequel le processus généré consommateur (T) ou producteur (S) de chaque canal, est adapté pour, après la fin d'une précédente itération dudit processus et préalablement au lancement de la nouvelle itération succédant à la précédente itération, délivrer à l'unité de synchronisation ($S_c$) du canal (c), la valeur d'itération de la nouvelle itération du processus, et mettre en oeuvre cette nouvelle itération du processus en fonction d'une commande de pilotage de l'unité de supervision indiquant un gel ou une autorisation.

**10.** Dispositif de synthèse de circuits selon la revendication 9, dans lequel le processus consommateur (T) du canal (c), après la fin d'une précédente itération dudit processus et préalablement au lancement de la nouvelle itération succédant à la précédente itération, est adapté pour délivrer en outre à l'unité de synchronisation ($S_c$) du canal, ladite valeur d'itération du processus producteur (S) qui donne lieu à l'écriture dans ledit canal de la donnée qui doit être lue par le processus consommateur lors de cette nouvelle itération.

**11.** Circuit synthétisé par la mise en oeuvre d'un procédé de synthèse automatique de circuit selon l'une des revendications 1 à 5, comprenant un réseau de processus réguliers interconnectés à l'aide de canaux (c), dans lequel chaque canal est une mémoire physique adressable, chacun desdits processus étant adapté pour appliquer, lors de chaque itération d'un domaine d'itérations qui lui est associé, au moins une lecture d'une donnée dans un canal et/ou une écriture d'une donnée dans un canal, et une fonction d'ordonnancement étant adaptée pour fournir, pour chaque valeur d'itération de chaque processus, une position d'exécution du processus sélectionnée dans un ensemble temporellement ordonné de positions d'exécution ;
ledit circuit étant **caractérisé en ce qu'**il comprend :

un unique processus, dit processus producteur (S), associé à chaque canal et autorisé à écrire des données dans le canal (c) et un unique processus, dit processus consommateur (T), associé à chaque canal et autorisé à lire des données dans ledit canal ; et
une unité de synchronisation ($S_c$) associée audit canal et adaptée pour collecter, préalablement au lancement de chaque nouvelle itération par le processus producteur du canal, la valeur ($t_p$, $i_p$) de ladite nouvelle itération du processus producteur, et collecter, préalablement au lancement de chaque nouvelle itération par le processus consommateur du canal, la valeur d'itération du processus consommateur (te, ic) ; ladite unité de synchronisation, suite à la collecte de la valeur d'une nouvelle itération du processus producteur, respectivement consommateur, étant adaptée pour autoriser ou geler la mise en oeuvre de ladite nouvelle itération dudit processus producteur, respectivement consommateur, en fonction d'une comparaison d'une position d'exécution déterminée en fonction de la valeur de nouvelle itération collectée du processus producteur, respectivement consommateur, et d'une position d'exécution déterminée en fonction de la dernière valeur d'itération collectée du processus consommateur, respectivement producteur.

**12.** Circuit synthétisé selon la revendication 11, dans lequel ladite unité de synchronisation ($S_c$) générée est adaptée pour piloter le fonctionnement du processus producteur (S) dudit canal (c) en mettant en oeuvre les étapes suivantes suite à la collecte de la valeur d'une nouvelle itération ($t_p$, $i_p$) dudit processus producteur :

- comparer la nouvelle position d'exécution ($\theta(t_P, i_P)$) de ladite valeur collectée, à la position d'exécution ($\theta(t_C, i_C)$) de la dernière valeur d'itération du processus consommateur (T) collectée ; et
- geler la mise en oeuvre par le processus producteur de cette nouvelle itération si la position d'exécution ($\theta(t_P, i_P)$) de cette nouvelle itération est postérieure à la position d'exécution ($\theta(t_C, i_C)$) de la dernière valeur d'itération collectée du processus consommateur, et maintenir le gel jusqu'à la collecte d'une future valeur d'itération du processus consommateur telle que la position d'exécution ($\theta(t_C, i_C)$) de cette future valeur d'itération soit postérieure à ladite position d'exécution ($\theta(t_P, i_P)$) de la nouvelle itération du processus consommateur.

**13.** Circuit synthétisé selon la revendication 11 ou 12, ladite unité de synchronisation ($S_c$) générée est adaptée pour piloter le fonctionnement du processus consommateur (T) dudit canal en mettant en oeuvre les étapes suivantes suite à la collecte de la valeur d'une nouvelle itération dudit processus consommateur :

- déterminer la position d'exécution ($\theta(t_S, i_S)$) de celle des valeurs d'itération du processus producteur (S) qui donne lieu à l'écriture dans ledit canal (c) de la donnée qui doit être lue par le processus consommateur lors de cette nouvelle itération, ; et
- geler la mise en oeuvre par le processus consommateur de sa nouvelle itération si la position d'exécution ($\theta(t_S, i_S)$) déterminée est postérieure ou égale à la position d'exécution ($\theta(t_P, i_P)$) de la dernière valeur d'itération collectée du processus producteur, et maintenir le gel jusqu'à la collecte d'une future valeur d'itération du processus producteur telle que la position d'exécution ($\theta(t_P, i_P)$) de cette future valeur d'itération soit supérieure strictement à ladite position d'exécution ($\theta(t_S, i_S)$) déterminée.

**14.** Circuit synthétisé selon l'une des revendications 11 à 13, dans lequel le processus généré consommateur (T) ou producteur (S) de chaque canal, est adapté pour, après la fin d'une précédente itération dudit processus et préalablement au lancement de la nouvelle itération succédant à la précédente itération, délivrer à l'unité de synchronisation (S$_c$) du canal (c), la valeur d'itération de la nouvelle itération du processus, et mettre en oeuvre cette nouvelle itération du processus en fonction d'une commande de pilotage de l'unité de supervision indiquant un gel ou une autorisation.

**15.** Circuit synthétisé selon la revendication 14, dans lequel le processus consommateur (T) du canal (c), après la fin d'une précédente itération dudit processus et préalablement au lancement de la nouvelle itération succédant à la précédente itération, est adapté pour délivrer en outre à l'unité de synchronisation (Sc) du canal, ladite valeur d'itération du processus producteur (S) qui donne lieu à l'écriture dans ledit canal de la donnée qui doit être lue par le processus consommateur lors de cette nouvelle itération.

**Patentansprüche**

**1.** Verfahren zur automatischen Synthese von Schaltungen, das einen Schritt der Kompilierung eines Softwareprogramms in einem Netz von regulären Prozessen enthält, die mit Hilfe von Kanälen (c) miteinander verbunden sind, wobei jeder Kanal ein adressierbarer physischer Speicher ist, wobei jeder der Prozesse bei jeder Iteration eines ihm zugeordneten Bereichs von Iterationen mindestens ein Lesen eines Datenwerts in einem Kanal und/oder ein Schreiben eines Datenwerts in einem Kanal anwendet, und eine Ordnungsfunktion für jeden Iterationswert jedes Prozesses eine in einer zeitlich geordneten Einheit von Ausführungspositionen ausgewählte Ausführungsposition des Prozesses liefert;
wobei das Schaltungssyntheseverfahren einen Schritt der Umwandlung des kompilierten Prozessnetzes in eine physische Schaltung enthält und **dadurch gekennzeichnet ist, dass** es im Kompilierungsschritt die folgenden Schritte für jeden der Kanäle (c) enthält:

ein einziger Prozess, Erzeugerprozess (S) genannt, ist berechtigt, Daten in den Kanal (c) zu schreiben, und ein einziger Prozess, Verbraucherprozess (T) genannt, ist berechtigt, Daten in dem Kanal zu lesen; und eine Synchronisationseinheit (S$_c$) ist dem Kanal zugeordnet, und derart, dass sie vor dem Start jeder neuen Iteration durch den Erzeugerprozess des Kanals den Wert ($t_p$, $i_p$) der neuen Iteration des Erzeugerprozesses sammelt, und vor dem Start jeder neuen Iteration durch den Verbraucherprozess des Kanals den Iterationswert ($t_c$, $i_c$) des Verbraucherprozesses sammelt; wobei die Synchronisationseinheit nach dem Sammeln des Werts einer neuen Iteration des Erzeuger- bzw. Verbraucherprozesses die Durchführung der neuen Iteration des Erzeuger- bzw. Verbraucherprozesses abhängig von einem Vergleich einer abhängig vom gesammelten Wert der neuen Iteration des Erzeuger- bzw. Verbraucherprozesses bestimmten Ausführungsposition und einer abhängig vom letzten gesammelten Iterationswert des Verbraucher- bzw. Erzeugerprozesses bestimmten Ausführungsposition berechtigt oder einfriert.

**2.** Verfahren zur automatischen Synthese von Schaltungen nach Anspruch 1, wobei die Synchronisationseinheit (S$_c$) so ist, dass sie den Betrieb des Erzeugerprozesses (S) des Kanals (c) steuert, indem sie nach dem Sammeln des Werts ($t_p$, $i_p$) einer neuen Iteration des Erzeugerprozesses die folgenden Schritte durchführt:

- die Synchronisationseinheit vergleicht die neue Ausführungsposition ($\theta(t_p, i_p)$) des gesammelten Werts mit der Ausführungsposition ($\theta(t_c, i_c)$) des letzten gesammelten Iterationswerts des Verbraucherprozesses (T); und
- die Synchronisationseinheit friert die Durchführung dieser neuen Iteration durch den Erzeugerprozess ein, wenn die Ausführungsposition ($\theta(t_p, i_p)$) dieser neuen Iteration nach der Ausführungsposition ($\theta(t_c, i_c)$) des letzten gesammelten Iterationswerts des Verbraucherprozess liegt, wobei das Einfrieren von der Synchronisationseinheit bis zum Sammeln eines zukünftigen Iterationswerts des Verbraucherprozesses derart, dass die Ausführungsposition ($\theta(t_c, i_c)$) dieses zukünftigen Iterationswerts nach der Ausführungsposition ($\theta(t_p, i_p)$) der neuen Iteration des Verbraucherprozesses liegt, beibehalten wird.

**3.** Verfahren zur automatischen Synthese von Schaltungen nach Anspruch 1 oder 2, wobei die Synchronisationseinheit (S$_c$) derart ist, dass sie den Betrieb des Verbraucherprozesses (T) des Kanals steuert, indem sie nach dem Sammeln des Werts einer neuen Iteration des Verbraucherprozesses die folgenden Schritte durchführt:

- die Synchronisationseinheit bestimmt die Ausführungsposition ($\theta(t_s, i_s)$) desjenigen der Iterationswerte des Erzeugerprozesses (S), der das Schreiben des Datenwerts in den Kanal (c) verursacht, der bei dieser neuen Iteration vom Verbraucherprozess gelesen werden soll; und

- die Synchronisationseinheit friert die Durchführung seiner neuen Iteration durch den Verbraucherprozess ein, wenn die bestimmte Ausführungsposition ($\theta(t_s, i_s)$) nach der der Ausführungsposition ($\theta(t_p, i_p)$) des letzten gesammelten Iterationswerts des Erzeugerprozesses liegt oder gleich ihr ist, wobei das Einfrieren von der Synchronisationseinheit bis zum Sammeln eines zukünftigen Iterationswerts des Erzeugerprozesses derart, dass die Ausführungsposition ($\theta(t_p, i_p)$) dieses zukünftigen Iterationswerts strikt höher als die bestimmte Ausführungsposition ($\theta(t_s, i_s)$) ist, beibehalten wird.

4. Verfahren zur automatischen Synthese von Schaltungen nach einem der Ansprüche 1 bis 3, wobei der Verbraucher-(T) oder Erzeugerprozess (S) jedes Kanals nach dem Ende einer vorhergehenden Iteration des Prozesses und vor dem Start der auf die vorhergehende Iteration folgenden neuen Iteration an die Synchronisationseinheit ($S_c$) des Kanals (c) den Iterationswert der neuen Iteration des Prozesses liefert und diese neue Iteration des Prozesses abhängig von einem Steuerbefehl der Überwachungseinheit durchführt, der ein Einfrieren oder eine Berechtigung anzeigt.

5. Schaltungssyntheseverfahren nach Anspruch 4, wobei der Verbraucherprozess (T) des Kanals (c) nach dem Ende einer vorhergehenden Iteration des Prozesses und vor dem Start der auf die vorhergehende Iteration folgenden neuen Iteration außerdem an die Synchronisationseinheit ($S_c$) des Kanals den Iterationswert des Erzeugerprozesses (S) liefert, der das Schreiben des Datenwerts in den Kanal verursacht, der bei dieser neuen Iteration von dem Verbraucherprozess gelesen werden soll.

6. Vorrichtung (1) zur automatischen Synthese von Schaltungen, die geeignet ist, eine Kompilierung eines Softwareprogramms auszuführen, indem sie ein Netz von regulären Prozessen generiert, die mit Hilfe von Kanälen (c) miteinander verbunden sind, wobei jeder Kanal ein adressierbarer physischer Speicher ist, wobei jeder der Prozesse geeignet ist, bei jeder Iteration eines ihm zugeordneten Bereichs von Iterationen mindestens ein Lesen eines Datenwerts in einem Kanal und/oder ein Schreiben eines Datenwerts in einem Kanal anzuwenden, und eine Ordnungsfunktion geeignet ist, für jeden Iterationswert jedes Prozesses eine Ausführungsposition des Prozesses zu liefern, die aus einer zeitlich geordneten Einheit von Ausführungspositionen ausgewählt wird;

wobei die Vorrichtung zur Synthese von Schaltungen geeignet ist, das kompilierte Prozessnetz in eine physische Schaltung umzuwandeln, und **dadurch gekennzeichnet ist, dass** sie geeignet ist, bei der Kompilierung zu generieren und jedem der Kanäle (c) zuzuordnen:

einen einzigen Prozess, Erzeugerprozess (S) genannt, der berechtigt ist, Daten in den Kanal (c) zu schreiben, und einen einzigen Prozess, Verbraucherprozess (T) genannt, der berechtigt ist, Daten in dem Kanal zu lesen; und

eine Synchronisationseinheit ($S_c$), die dem Kanal zugeordnet und geeignet ist, vor dem Start jeder neuen Iteration durch den Erzeugerprozess des Kanals den Wert ($t_p, i_p$) der neuen Iteration des Erzeugerprozesses zu sammeln, und vor dem Start jeder neuen Iteration durch den Verbraucherprozess des Kanals den Iterationswert ($t_c, i_c$) des Verbraucherprozesses zu sammeln; wobei die Synchronisationseinheit nach dem Sammeln des Werts einer neuen Iteration des Erzeuger- bzw. Verbraucherprozesses geeignet ist, die Durchführung der neuen Iteration des Erzeuger- bzw. Verbraucherprozesses abhängig von einem Vergleich einer bestimmten Ausführungsposition abhängig vom gesammelten Wert einer neuen Iteration des Erzeuger- bzw. Verbraucherprozesses und einer bestimmten Ausführungsposition abhängig vom letzten gesammelten Iterationswert des Verbraucher- bzw. Erzeugerprozesses zu berechtigen oder einzufrieren.

7. Vorrichtung (1) zur automatischen Synthese von Schaltungen nach Anspruch 6, wobei die generierte Synchronisationseinheit ($S_c$) geeignet ist, den Betrieb des Erzeugerprozesses (S) des Kanals (c) zu steuern, indem sie nach dem Sammeln des Werts ($t_p, i_p$) einer neuen Iteration des Erzeugerprozesses die folgenden Schritte durchführt:

- Vergleichen der neuen Ausführungsposition ($\theta(t_p, i_p)$) des gesammelten Werts mit der Ausführungsposition ($\theta(t_c, i_c)$) des letzten gesammelten Iterationswerts des Verbraucherprozesses (T); und
- Einfrieren der Durchführung dieser neuen Iteration durch den Erzeugerprozess, wenn die Ausführungsposition ($\theta(t_p, i_p)$) dieser neuen Iteration nach der Ausführungsposition ($\theta(t_c, i_c)$) des letzten gesammelten Iterationswerts des Verbraucherprozesses liegt, und Beibehalten des Einfrierens bis zum Sammeln eines zukünftigen Iterationswerts des Verbraucherprozesses, derart, dass die Ausführungsposition ($\theta(t_c, i_c)$) dieses zukünftigen Iterationswerts nach der Ausführungsposition ($\theta(t_p, i_p)$) der neuen Iteration des Verbraucherprozesses liegt.

8. Vorrichtung (1) zur automatischen Synthese von Schaltungen nach Anspruch 6 oder 7, wobei die generierte Synchronisationseinheit ($S_c$) geeignet ist, den Betrieb des Verbraucherprozesses (T) des Kanals zu steuern, indem nach dem Sammeln des Werts einer neuen Iteration des Verbraucherprozesses die folgenden Schritte durchgeführt werden:

- Bestimmen der Ausführungsposition ($\theta(t_s, i_s)$) desjenigen der Iterationswerte des Erzeugerprozesses (S), der das Schreiben des Datenwerts in den Kanal (c) verursacht, der bei dieser neuen Iteration vom Verbraucherprozess gelesen werden soll; und
- Einfrieren der Durchführung seiner neuen Iteration durch den Verbraucherprozess, wenn die bestimmte Ausführungsposition ($\theta(t_s, i_s)$) nach der Ausführungsposition ($\theta(t_p, i_p)$) des letzten gesammelten Iterationswerts des Erzeugerprozesses liegt oder gleich ihr ist, und Beibehalten des Einfrierens bis zum Sammeln eines zukünftigen Iterationswerts des Erzeugerprozesses derart, dass die Ausführungsposition ($\theta(t_p, i_p)$) dieses zukünftigen Iterationswerts strikt höher ist als die bestimmte Ausführungsposition ($\theta(t_s, i_s)$).

9. Vorrichtung zur automatischen Synthese von Schaltungen nach einem der Ansprüche 6 bis 8, wobei der generierte Verbraucher- (T) oder Erzeugerprozess (S) jedes Kanals geeignet ist, nach dem Ende einer vorhergehenden Iteration des Prozesses und vor dem Start der auf die vorhergehende Iteration folgenden neuen Iteration an die Synchronisationseinheit ($S_c$) des Kanals (c) den Iterationswert der neuen Iteration des Prozesses zu liefern, und diese neue Iteration des Prozesses abhängig von einem Steuerbefehl der Überwachungseinheit durchzuführen, der ein Einfrieren oder eine Berechtigung anzeigt.

10. Vorrichtung zur Synthese von Schaltungen nach Anspruch 9, wobei der Verbraucherprozess (T) des Kanals (c) nach dem Ende einer vorhergehenden Iteration des Prozesses und vor dem Start der auf die vorhergehende Iteration folgenden neuen Iteration geeignet ist, außerdem an die Synchronisationseinheit ($S_c$) des Kanals den Iterationswert des Erzeugerprozesses (S) zu liefern, der das Schreiben des Datenwerts in den Kanal verursacht, der vom Verbraucherprozess bei dieser neuen Iteration gelesen werden soll.

11. Schaltung, die durch die Durchführung eines Verfahrens zur automatischen Synthese von Schaltungen nach einem der Ansprüche 1 bis 5 synthetisiert wird, die ein Netz von mit Hilfe von Kanälen (c) miteinander verbundenen regulären Prozessen enthält, wobei jeder Kanal ein adressierbarer physischer Speicher ist, wobei jeder der Prozesse geeignet ist, bei jeder Iteration eines ihm zugeordneten Bereichs von Iterationen mindestens ein Lesen eines Datenwerts in einem Kanal und/oder mindestens ein Schreiben eines Datenwerts in einen Kanal anzuwenden, und wobei eine Ordnungsfunktion geeignet ist, für jeden Iterationswert jedes Prozesses eine Ausführungsposition des Prozesses zu liefern, die in einer zeitlich geordneten Einheit von Ausführungspositionen ausgewählt wird; wobei die Schaltung **dadurch gekennzeichnet, dass** sie enthält:

einen einzigen Prozess, Erzeugerprozess (S) genannt, der jedem Kanal zugeordnet und berechtigt ist, Daten in den Kanal (c) zu schreiben, und einen einzigen Prozess, Verbraucherprozess (T) genannt, der jedem Kanal zugeordnet und berechtigt ist, Daten in dem Kanal zu lesen; und
eine Synchronisationseinheit ($S_c$), die dem Kanal zugeordnet und geeignet ist, vor dem Start jeder neuen Iteration durch den Erzeugerprozess des Kanals den Wert ($t_p, i_p$) der neuen Iteration des Erzeugerprozesses zu sammeln, und vor dem Start jeder neuen Iteration durch den Verbraucherprozess des Kanals den Iterationswert ($t_c, i_c$) des Verbraucherprozesses zu sammeln; wobei die Synchronisationseinheit nach dem Sammeln des Werts einer neuen Iteration des Erzeuger- bzw. Verbraucherprozesses geeignet ist, die Durchführung der neuen Iteration des Erzeuger- bzw. Verbraucherprozesses abhängig von einem Vergleich einer abhängig vom neuen gesammelten Wert einer Iteration des Erzeuger- bzw. Verbraucherprozesses bestimmten Ausführungsposition und einer abhängig vom letzten gesammelten Iterationswert des Verbraucher- bzw. Erzeugerprozesses bestimmten Ausführungsposition zu berechtigen oder einzufrieren.

12. Synthetisierte Schaltung nach Anspruch 11, wobei die generierte Synchronisationseinheit ($S_c$) geeignet ist, den Betrieb des Erzeugerprozesses (S) des Kanals (c) zu steuern, indem sie nach dem Sammeln des Werts ($t_p, i_p$) einer neuen Iteration des Erzeugerprozesses die folgenden Schritte durchführt:

- Vergleich der neuen Ausführungsposition ($\theta(t_p, i_p)$) des gesammelten Werts mit der Ausführungsposition ($\theta(t_c, i_c)$) des letzten gesammelten Iterationswerts des Verbraucherprozesses (T); und
- Einfrieren der Durchführung dieser neuen Iteration durch den Erzeugerprozess, wenn die Ausführungsposition ($\theta(t_p, i_p)$) diese neuen Iteration nach der Ausführungsposition ($\theta(tc, ic)$) des letzten gesammelten Iterationswerts des Verbraucherprozesses liegt, und Beibehalten des Einfrierens bis zum Sammeln eines zukünftigen Iterationswerts des Verbraucherprozesses derart, dass die Ausführungsposition ($\theta(t_c, i_c)$) dieses zukünftigen Iterati-

onswerts nach der Ausführungsposition ($\theta(t_p, i_p)$) der neuen Iteration des Verbraucherprozesses liegt.

13. Synthetisierte Schaltung nach Anspruch 11 oder 12, wobei die generierte Synchronisationseinheit ($S_c$) geeignet ist, den Betrieb des Verbraucherprozesses (T) des Kanals zu steuern, indem sie nach dem Sammeln des Werts einer neuen Iteration des Verbraucherprozesses die folgenden Schritte durchführt:

- Bestimmen der Ausführungsposition ($\theta(t_s, i_s)$) desjenigen der Iterationswerte des Erzeugerprozesses (S), der das Schreiben des Datenwerts in den Kanal (c) verursacht, der vom Verbraucherprozess bei dieser neuen Iteration gelesen werden soll; und
- Einfrieren der Durchführung seiner neuen Iteration durch den Verbraucherprozess, wenn die bestimmte Ausführungsposition ($\theta(t_s, i_s)$) nach der Ausführungsposition ($\theta(t_p, i_p)$) des letzten gesammelten Iterationswerts des Erzeugerprozesses liegt oder gleich ihr ist, und Beibehalten des Einfrierens bis zum Sammeln eines zukünftigen Iterationswerts des Erzeugerprozesses derart, dass die Ausführungsposition ($\theta(t_p, i_p)$) dieses zukünftigen Iterationswerts strikt höher ist als die bestimmte Ausführungsposition ($\theta(t_s, i_s)$).

14. Synthetisierte Schaltung nach einem der Ansprüche 11 bis 13, wobei der generierte Verbraucher- (T) oder Erzeugerprozess (S) jedes Kanals geeignet ist, nach dem Ende einer vorhergehenden Iteration des Prozesses und vor dem Start der auf die vorhergehende Iteration folgenden neuen Iteration an die Synchronisationseinheit ($S_c$) des Kanals (c) den Iterationswert der neuen Iteration des Prozesses zu liefern, und diese neue Iteration des Prozesses abhängig von einem Steuerbefehl der Überwachungseinheit durchzuführen, der ein Einfrieren oder eine Berechtigung anzeigt.

15. Synthetisierte Schaltung nach Anspruch 14, wobei der Verbraucherprozess (T) des Kanals (c) nach dem Ende einer vorhergehenden Iteration des Prozesses und vor dem Start der auf die vorhergehende Iteration folgenden neuen Iteration geeignet ist, außerdem an die Synchronisationseinheit ($S_c$) des Kanals den Iterationswert des Erzeugerprozesses (S) zu liefern, der das Schreiben des Datenwerts in den Kanal verursacht, der bei dieser neuen Iteration vom Verbraucherprozess gelesen werden soll.

## Claims

1. A method for automatic synthesis of circuits comprising a step of compiling a software program into a network of regular processes interconnected using channels (c), according to which each channel is an addressable physical memory, each of said processes applies, during each iteration of an iteration domain with which it is associated, at least one data read in a channel and/or one data write in a channel, and a sequencing function provides, for each iteration value of each process, an execution position of the process selected in a time-sequenced set of execution positions;
said circuit synthesis method comprising a step of transforming said network of processes compiled into a physical circuit and being **characterised in that** it comprises the following steps, during the compilation step, for each of said channels (c):

one single process, so-called producer process (S), is authorised to write data in the channel (c) and one single process, so-called consumer process (T), is authorised to read data in said channel; and
a synchronisation unit ($S_c$) is associated with said channel, and such that it collects, prior to launch of each new iteration by the producer process of the channel, the value ($t_P$, $i_P$) of said new iteration of the producer process, and collects, prior to launch of each new iteration by the consumer process of the channel, the iteration value of the consumer process ($t_C$, $i_C$); said synchronisation unit, following the collection of the value of a new iteration of the producer, respectively consumer, process, authorising or freezing the implementation of said new iteration of said producer, respectively consumer, process, according to a comparison of an execution position determined according to the new collected iteration value of the producer, respectively consumer, process, and an execution position determined according to the last collected iteration value of the consumer, respectively producer, process.

2. The circuit automatic synthesis method according to claim 1, according to which said synchronisation unit ($S_c$) is such that it controls the operation of the producer process (S) of said channel (c) by implementing the next steps following the collection of the value of a new iteration ($t_P$, $i_P$) of said producer process:

- the synchronisation unit compares the new execution position ($\theta(t_P, i_P)$) of said collected value, to the execution

position ($\theta(t_C, i_C)$) of the last collected iteration value of the consumer process (T); and
- said synchronisation unit freezes the implementation by the producer process of this new iteration if the execution position ($\theta(t_P, i_P)$) of this new iteration is subsequent to the execution position ($\theta(t_C, i_C)$) of the last collected iteration value of the consumer process, freezing being maintained by the synchronisation until collection of a future iteration value of the consumer process such that the execution position ($\theta(t_C, i_C)$) of this future iteration value is subsequent to said execution position ($\theta(t_P, i_P)$) of the new iteration of the consumer process.

**3.** The circuit automatic synthesis method according to claim 1 or 2, according to which said synchronisation unit ($S_c$) is such that it controls the operation of the consumer process (T) of said channel by implementing the next steps following the collection of the value of a new iteration of said consumer process:

- the synchronisation unit determines the execution position ($\theta(t_S, i_S)$) of that one amongst the iteration values of the producer process (S) which causes writing in said channel (c) the data that should be read by the consumer process during this new iteration; and
- said synchronisation unit freezes the implementation by the consumer process of its new iteration if the determined execution position ($\theta(t_S, i_S)$) is subsequent or equal to the execution position ($\theta(t_P, i_P)$) of the last collected iteration value of the producer process, freezing being maintained by the synchronisation unit until collection of a future iteration value of the producer process such that the execution position ($\theta(t_P, i_P)$) of this future iteration value is strictly higher than said determined execution position ($\theta(t_S, i_S)$).

**4.** The circuit automatic synthesis method according to one of claims 1 to 3, according to which the consumer (T) or producer (S) process of each channel after the end of a previous iteration of said process and prior to launch of the new iteration following the previous iteration, delivers to the synchronisation unit ($S_c$) of the channel (c), the iteration value of the new iteration of the process, and implements this new iteration of the process according to a control command from the supervision unit indicating a freeze or an authorisation.

**5.** The circuit automatic synthesis method according to claim 4, according to which the consumer (T) process of the channel (c), after the end of a previous iteration of said process and prior to launch of the new iteration following the previous iteration, also delivers to the synchronisation unit ($S_c$) of the channel, said iteration value of the producer process (S) which causes writing in said channel the data that should be read by the consumer process during this new iteration.

**6.** A device (1) for automatic synthesis of circuits adapted to perform a compilation of a software program by generating a network of regular processes interconnected using channels (c), wherein each channel is an addressable physical memory, each of said processes being adapted to apply, during each iteration of an iteration domain with which it is associated, at least one data read in a channel and/or one data write in a channel, and a sequencing function being adapted to provide, for each iteration value of each process, an execution position of the process selected in a time-sequenced set of execution positions;
said circuit synthesis device being adapted to transform said network of processes compiled into a physical circuit and being **characterised in that** it is adapted, during said compilation, to generate and associate with each of said channels (c):

one single process, so-called producer process (S), authorised to write data in the channel (c) and one single process, so-called consumer process (T), authorised to read data in said channel; and
a synchronisation unit ($S_c$) associated with said channel, and adapted to collect, prior to launch of each new iteration by the producer process of the channel, the value ($t_P, i_P$) of said new iteration of the producer process, and to collect, prior to launch of each new iteration by the consumer process of the channel, the iteration value of the consumer process ($t_C, i_C$); said synchronisation unit, following the collection of the value of a new iteration of the producer, respectively consumer, process, being adapted to authorise or freeze the implementation of said new iteration of said producer, respectively consumer, process, according to a comparison of an execution position determined according to the new collected iteration value of the producer, respectively consumer, process, and an execution position determined according to the last collected iteration value of the consumer, respectively producer, process.

**7.** The circuit automatic synthesis device (1) according to claim 6, wherein said generated synchronisation unit ($S_c$) is adapted to control the operation of the producer process (S) of said channel (c) by implementing the next steps following the collection of the value of a new iteration ($t_P, i_P$) of said producer process:

- comparing the new execution position ($\theta(t_P, i_P)$) of said collected value, to the execution position ($\theta(t_C, i_C)$) of the last collected iteration value of the consumer process (T); and
- freezing the implementation by the producer process of this new iteration if the execution position ($\theta(t_P, i_P)$) of this new iteration is subsequent to the execution position ($\theta(t_C, i_C)$) of the last collected iteration value of the consumer process, and maintaining freezing until collection of a future iteration value of the consumer process such that the execution position ($\theta(t_C, i_C)$) of this future iteration value is subsequent to said execution position ($\theta(t_P, i_P)$) of the new iteration of the consumer process.

8. The circuit automatic synthesis device (1) according to claim 6 or 7, said generated synchronisation unit ($S_c$) is adapted to control the operation of the consumer process (T) of said channel by implementing the next steps following the collection of the value of a new iteration of said consumer process:

- determining the execution position ($\theta(t_S, i_S)$) of that one amongst the iteration values of the producer process (S) which causes writing in said channel (c) the data that should be read by the consumer process during this new iteration; and
- freezing the implementation by the consumer process of its new iteration if the determined execution position ($\theta(t_S, i_S)$) is subsequent or equal to the execution position ($\theta(t_P, i_P)$) of the last collected iteration value of the producer process, and maintaining freezing until collection of a future iteration value of the producer process such that the execution position ($\theta(t_P, i_P)$) of this future iteration value is strictly higher than said determined execution position ($\theta(t_S, i_S)$).

9. The circuit automatic synthesis device according to one of claims 6 to 8, wherein the generated consumer (T) or producer (S) process of each channel is adapted, after the end of a previous iteration of said process and prior to launch of the new iteration following the previous iteration, to deliver to the synchronisation unit ($S_c$) of the channel (c), the iteration value of the new iteration of the process, and to implement this new iteration of the process according to a control command from the supervision unit indicating a freeze or an authorisation.

10. The circuit synthesis device according to claim 9, wherein the consumer process (T) of the channel (c), after the end of a previous iteration of said process and prior to launch of the new iteration following the previous iteration, is adapted to also deliver to the synchronisation unit ($S_c$) of the channel, said iteration value of the producer process (S) which causes writing in said channel the data that should be read by the consumer process during this new iteration.

11. A circuit synthesised by implementation of a circuit automatic synthesis method according to one of claims 1 to 5, comprising a network of regular processes interconnected using channels (c), wherein each channel is an addressable physical memory, each of said processes being adapted to apply, during each iteration of an iteration domain with which it is associated, at least one data read in a channel and/or one data write in a channel, and a sequencing function being adapted to provide, for each iteration value of each process, an execution position of the process selected in a time-sequenced set of execution positions;
said circuit being **characterised in that** it comprises:

one single process, so-called producer process (S), associated with each channel authorised to write data in the channel (c) and one single process, so-called consumer process (T), associated with each channel and authorised to read data in said channel; and
a synchronisation unit ($S_c$) associated with said channel, and adapted to collect, prior to launch of each new iteration by the producer process of the channel, the value ($t_P, i_P$) of said new iteration of the producer process, and to collect, prior to launch of each new iteration by the consumer process of the channel, the iteration value of the consumer process ($t_C, i_C$); said synchronisation unit, following the collection of the value of a new iteration of the producer, respectively consumer, process, being adapted to authorise or freeze the implementation of said new iteration of said producer, respectively consumer, process, according to a comparison of an execution position determined according to the new collected iteration value of the producer, respectively consumer, process, and an execution position determined according to the last collected iteration value of the consumer, respectively producer, process.

12. The synthesised circuit according to claim 11, wherein said generated synchronisation unit ($S_c$) is adapted to control the operation of the producer process (S) of said channel (c) by implementing the next steps following the collection of the value of a new iteration ($t_P, i_P$) of said producer process:

- comparing the new execution position ($\theta(t_P, i_P)$) of said collected value, to the execution position ($\theta(t_C, i_C)$) of the last collected iteration value of the consumer process (T); and

- freezing the implementation by the producer process of this new iteration if the execution position ($\theta(t_P, i_P)$) of this new iteration is subsequent to the execution position ($\theta(t_C, i_C)$) of the last collected iteration value of the consumer process, and maintaining freezing until collection of a future iteration value of the consumer process such that the execution position ($\theta(t_C, i_C)$) of this future iteration value is subsequent to said execution position ($\theta(t_P, i_P)$) of the new iteration of the consumer process.

13. The synthesised circuit according to claim 11 or 12, said generated synchronisation unit ($S_c$) is adapted to control the operation of the consumer process (T) of said channel by implementing the next steps following the collection of the value of a new iteration of said consumer process:

- determining the execution position ($\theta(t_S, i_S)$) of that one amongst the iteration values of the producer process (S) which causes writing in said channel (c) the data that should be read by the consumer process during this new iteration; and

- freezing the implementation by the consumer process of its new iteration if the determined execution position ($\theta(t_S, i_S)$) is subsequent or equal to the execution position ($\theta(t_P, i_P)$) of the last collected iteration value of the producer process, and maintaining freezing until collection of a future iteration value of the producer process such that the execution position ($\theta(t_P, i_P)$) of this future iteration value is strictly higher than said determined execution position ($\theta(t_S, i_S)$).

14. The synthesised circuit according to one of claims 11 to 13, wherein the generated consumer (T) or producer (S) process of each channel, is adapted, after the end of a previous iteration of said process and prior to launch of the new iteration following the previous iteration, to deliver to the synchronisation unit ($S_c$) of the channel (c), the iteration value of the new iteration of the process, and to implement this new iteration of the process according to a control command from the supervision unit indicating a freeze or an authorisation.

15. The synthesised circuit according to claim 14, wherein the consumer process (T) of the channel (c), after the end of a previous iteration of said process and prior to launch of the new iteration following the previous iteration, is adapted to also deliver to the synchronisation unit ($S_c$) of the channel, said iteration value of the producer process (S) which causes writing in said channel the data that should be read by the consumer process during this new iteration.

## FIG.1

## FIG.2

## FIG.3

```
    a[0]=0          LOAD(a)         a[N−1]=0
    DEMUX           DEMUX           DEMUX

    buf0    buf1[N]  buf2[N]  buf3[N]   buf4

buf8             MUX1   MUX2   MUX3

MUX              b[i] = a[i−1] + a[i] + a[i+1]          FIG.4

result = a[1]    DEMUX

DEMUX            buf5[1][N]

buf9             MUX

MUX              a[i] = b[i]                buf7[1][N]

STORE            DEMUX                      MUX
(result)
                                           STORE(a)
         buf6[1][N]  buf6[1][N]  buf6[1][N]
```

```
         MUX1   MUX2   MUX3

S        b[i] = a[i−1] + a[i] + a[i+1]              Cmd_S

         DEMUX
                                    (tp,ip)
C        buf5[1][N]
                                                    Synchro.
         MUX                (ts,is)

FIG.5                       (tc,ic)              S_C

T        a[i] = b[i]                             Cmd_T

         DEMUX
```

**RÉFÉRENCES CITÉES DANS LA DESCRIPTION**

**Littérature non-brevet citée dans la description**

- Enabling Automatic Pipeline Utilization Improvement in Polyhedral Process Network Implementations. **SVEN VAN ASTREGT ; BART KIENHUIS.** APPLICATION-SPECIFIC SYSTEMS, ARCHITECTURES AND PROCESSORS (ASAP), 2012 IEEE 23RD INTERNATIONAL CONFERENCE ON. IEEE, 09 Juillet 2012, 173-176

- Optimizing DDR-SDRAM Communications at C-Level for Automatically-Generated Hardware Accelerators. An Expérience with the Altera C2H HLS Tool. **CHRISTOPHE ALIAS ; ALAIN DARTE ; ALEXANDRU PLESCO.** 21st IEEE International Conférence on Application-specific Systems, Architectures and Processors (ASAP'10). IEEE Computer Society, Juillet 2010, 329-332